# EUROPEAN PATENT APPLICATION

(11) **EP 4 507 471 A1**
(43) Date of publication of application: **12.02.2025**
(21) Application number: 24168991.8
(22) Date of filing: 08.04.2024
(51) Int. Cl.: H10B 12/00, H01L 29/786

(54) **SEMICONDUCTOR MEMORY DEVICE**

(30) Priority: 11.08.2023 KR 20230105783
(71) Applicant: Samsung Electronics Co., Ltd., Suwon-si, Gyeonggi-do 16677 (KR)
(72) Inventor: LEE, Ju Ho, 16677 Suwon-si (KR); LEE, Yu Yeol, 16677 Suwon-si (KR); KIM, Seung Hyun, 16677 Suwon-si (KR); BYEON, Seong Jae, 16677 Suwon-si (KR); HONG, Sung Duk, 16677 Suwon-si (KR)
(74) Representative: Marks & Clerk LLP

(57) **Abstract**

A semiconductor memory device is provided that includes a bit line on a substrate, a protruded insulating pattern on the bit line, and in a channel trench, first and second channel patterns that extend along sidewalls of the channel trench, and spaced apart from the first channel pattern in the first direction, a channel interfacial layer that extends along the sidewalls of the channel trench, and is in contact with the first channel pattern and the second channel pattern, a first word line between the first channel pattern and the second channel pattern, a second word line between the first channel pattern and the second channel pattern, and is spaced apart from the first word line in the first direction and a first capacitor and a second capacitor, which are electrically connected to the first channel pattern and the second channel pattern.

## Description

### BACKGROUND

The present disclosure relates to a semiconductor memory device and more particularly, to a semiconductor memory device that includes a vertical channel transistor (VCT).

It has been suggested to increase the degree of integration of a semiconductor memory device to fulfil excellent performance and low cost, which are desired by consumers. In case of semiconductor memory devices, since the degree of integration is an important factor that determines the price of a product, the increased degree of integration has been especially desirable.

In case of a two-dimensional or planar semiconductor memory device, since the degree of integration is mainly determined by an area occupied by a unit memory cell, it is greatly affected by the level of the technology for forming a fine pattern. However, since ultrahigh-priced equipment is required for the fine pattern, the degree of integration of the two-dimensional semiconductor memory device is increasing but may be restrictive. Therefore, semiconductor memory devices including a vertical channel transistor of which a channel extends in a vertical direction have been proposed.

### SUMMARY

An object of the present disclosure is to provide a semiconductor memory device having improved degree of integration and electrical characteristics.

According to some aspects of the present inventive concept, there is provided a semiconductor memory device including a bit line that extends in a first direction on a substrate, a protruded insulating pattern on the bit line, and in a channel trench, a first channel pattern that extends along a first sidewall of the channel trench, and includes a first metal oxide, a second channel pattern that extends along a second sidewall of the channel trench, and includes the first metal oxide, and is spaced apart from the first channel pattern in the first direction, a channel interfacial layer that extends along the first and second sidewalls of the channel trench, and is in contact with the first channel pattern and the second channel pattern, a first word line between the first channel pattern and the second channel pattern and that extends in a second direction, a second word line between the first channel pattern and the second channel pattern, that extends in the second direction, and is spaced apart from the first word line in the first direction, and a first capacitor and a second capacitor, which are electrically connected to the first channel pattern and the second channel pattern respectively, and are on the first channel pattern and the second channel pattern.

The protruded insulating pattern may protrude in a third direction, perpendicular to the first direction and second direction. The channel trench may be formed within the protruded insulating pattern. Sidewalls of the protruded insulating pattern may define the channel trench. The first channel pattern may extend along a first sidewall of the channel trench. The second channel pattern may extend along a second sidewall of the channel trench. The second sidewall may be opposite to the first sidewall.

According to some aspects of the present inventive concept, there is provided a semiconductor memory device comprises a peripheral gate structure on a substrate, a bit line on the peripheral gate structure and that extends in a first direction, a protruded insulating pattern on the bit line, and in a channel trench, a channel structure on the bit line, and including a horizontal portion and first and second vertical portions, which are inside the channel trench, the first and second vertical portions protrude from the horizontal portion, and the horizontal portion of the channel structure are in contact with the bit line, a channel interfacial layer between the protruded insulating pattern and the channel structure, a first word line on the channel structure and the first word line extends in a second direction that intersects the first direction, a second word line on the channel structure, the second word line extends in the second direction and is spaced apart from the first word line in the first direction, a gate isolation pattern on the horizontal portion of the channel structure, the gate isolation pattern separates the first word line and the second word line from each other and a first capacitor and a second capacitor, which are respectively electrically connected to the first vertical portion of the channel structure and the second vertical portion of the channel structure.

According to some aspects of the present inventive concept, there is provided a semiconductor memory device that includes a peripheral gate structure on a substrate, a bit line on the peripheral gate structure and the bit line extends in a first direction, a protruded insulating pattern on the bit line, and in a channel trench, a channel structure on the bit line, the channel structure includes a horizontal portion and first and second vertical portions, which are inside the channel trench, the first and second vertical portions protrude from the horizontal portion, and the horizontal portion of the channel structure is in contact with the bit line, a channel interfacial layer between the protruded insulating pattern and the channel structure and between the bit line and the channel structure, a first word line on the channel structure and the first word line extends in a second direction that intersects the first direction, a second word line on the channel structure, the second word line extends in the second direction and is spaced apart from the first word line in the first direction, a gate isolation pattern on the horizontal portion of the channel structure, the gate isolation pattern separates the first word line and the second word line from each other, and a first capacitor and a second capacitor, which are respectively electrically connected to the first vertical portion of the channel structure and the second vertical portion of the channel structure.

However, aspects of the present disclosure are not restricted to those set forth herein. At least some of the above and other features of the claims are set out in the claims. The above and other aspects of the present disclosure will become more apparent to one of ordinary skill in the art to which the present disclosure pertains by referencing the detailed description of the present disclosure given below.

### BRIEF DESCRIPTION OF THE DRAWINGS

The above and other aspects and features of the present disclosure will become more apparent by describing in detail illustrative embodiments thereof with reference to the attached drawings, in which:
FIG. 1 is a layout view illustrating a semiconductor memory device according to some embodiments.
FIG. 2 is a cross-sectional view taken along lines A-A and B-B of FIG. 1.
FIG. 3 is a cross-sectional view taken along lines C-C and D-D of FIG. 1.
FIGS. 4 to 6 are enlarged views illustrating a portion P of FIG. 2.
FIG. 7 is a view illustrating a semiconductor memory device according to some embodiments.
FIG. 8 is a view illustrating a semiconductor memory device according to some embodiments.
FIG. 9 is a view illustrating a semiconductor memory device according to some embodiments.
FIG. 10 is a view illustrating a semiconductor memory device according to some embodiments.
FIGS. 11 to 13 are views illustrating a semiconductor memory device according to some embodiments.
FIGS. 14 to 17 are views illustrating a semiconductor memory device according to some embodiments.
FIGS. 18 to 21 are views illustrating a semiconductor memory device according to some embodiments.
FIGS. 22 to 32 are views illustrating a method for fabricating a semiconductor memory device according to some embodiments.
FIGS. 33 and 34 are views illustrating a method for fabricating a semiconductor memory device according to some embodiments.

### DETAILED DESCRIPTION

It will be understood that, although the terms "first", "second", etc. may be used herein to describe various elements or components, these elements or components should not be limited by these terms. These terms are only used to distinguish one element or component from another element or component. Therefore, a first element or component discussed below could be termed a second element or component without departing from the scope of the present disclosure.

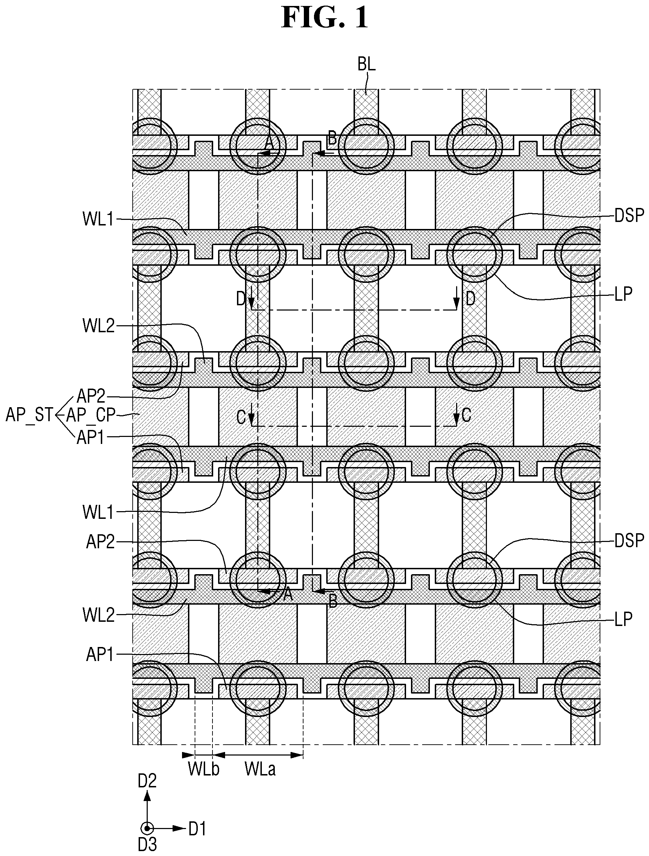

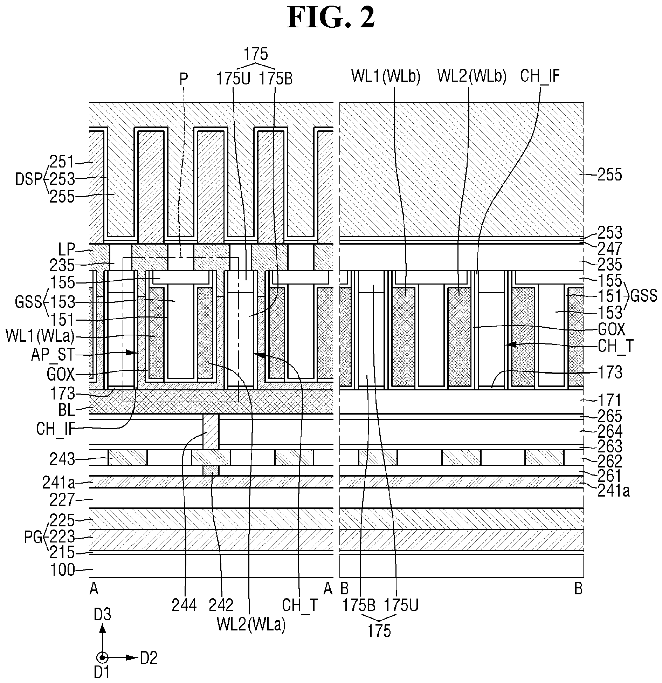

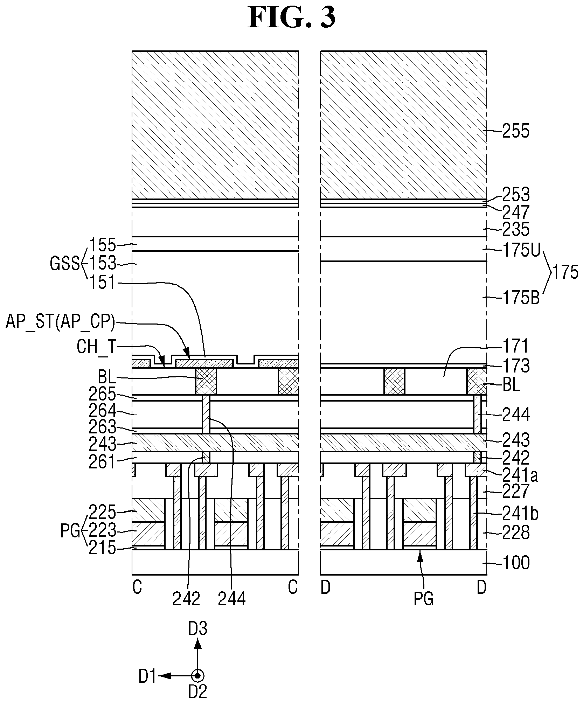

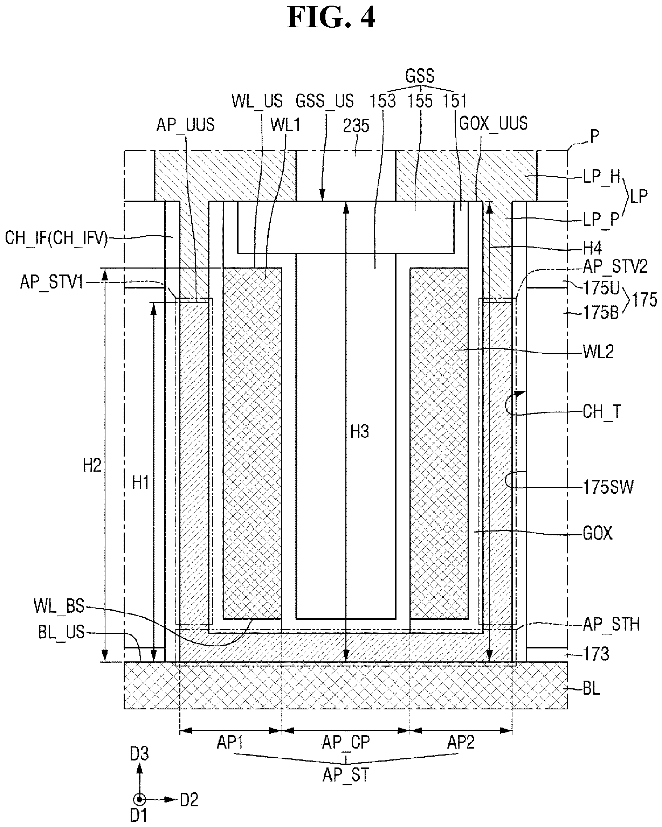

FIG. 1 is a layout view illustrating a semiconductor memory device according to some embodiments. FIG. 2 is a cross-sectional view taken along lines A-A and B-B of FIG. 1. FIG. 3 is a cross-sectional view taken along lines C-C and D-D of FIG. 1. FIGS. 4 to 6 are enlarged views illustrating a portion P of FIG. 2.

A semiconductor memory device according to embodiments of the present disclosure may include memory cells that include a vertical channel transistor (VCT).

Referring to FIGS. 1 to 6, the semiconductor memory device according to some embodiments may include a peripheral gate structure PG, bit lines BL, word lines WL1 and WL2, channel gate structures AP_ST, a protruded insulating pattern 175, channel interfacial layers CH_IF, and data storage patterns DSP.

A substrate 100 may be a silicon substrate, or may include other materials such as silicon germanium, indium antimonide, lead telluride, indium arsenide, indium phosphide, gallium arsenide or gallium antimonide, but is not limited thereto.

The peripheral gate structure PG may be disposed on the substrate 100. The substrate 100 may include a cell array region and a peripheral circuit region. The peripheral gate structure PG may be disposed over the cell array region and the peripheral circuit region. In other words, a portion of the peripheral gate structure PG may be disposed in the cell array region of the substrate 100, and the rest of the peripheral gate structure PG excluding the portion may be disposed in the peripheral circuit region of the substrate 100.

The peripheral gate structure PG may be included in a sensing transistor, a transfer transistor, a driving transistor and/or the like. Types of transistors disposed in the cell array region and the peripheral circuit region may be varied depending on a design arrangement of the semiconductor memory device.

The peripheral gate structure PG may include a peripheral gate insulating layer 215, a peripheral lower conductive pattern 223 and a peripheral upper conductive pattern 225. The peripheral gate insulating layer 215 may include a silicon oxide layer, a silicon oxynitride layer, a high dielectric constant insulating layer (e.g. a layer having a dielectric constant higher than that of a silicon oxide layer) or their combination. The high dielectric constant insulating layer may include at least one of, for example, a metal oxide, a metal oxynitride, a metal silicon oxide or a metal silicon oxynitride, but is not limited thereto.

Each of the peripheral lower conductive pattern 223 and the peripheral upper conductive pattern 225 may include a conductive material. For example, each of the peripheral lower conductive pattern 223 and the peripheral upper conductive pattern 225 may include at least one of a doped semiconductor material, a conductive metal nitride, a conductive metal silicon nitride, a metal carbonitride, a conductive metal silicide, a conductive metal oxide, a two-dimensional (2D) material, a metal or a metal alloy. The peripheral gate structure PG is shown as including a plurality of conductive patterns, but is not limited thereto.

In the semiconductor memory device according to some embodiments, the two-dimensional material may be a metallic material and/or a semiconductor material. The two-dimensional (2D) material may include a two-dimensional allotrope or a two-dimensional compound, and may include at least one of, for example, graphene, molybdenum disulfide (MoS₂), molybdenum diselenide (MoSe₂), tungsten diselenide (WSe₂) or tungsten disulfide (WS₂), but is not limited thereto. That is, since the two-dimensional materials described above are examples, the two-dimensional material that may be included in the semiconductor memory device of the present disclosure is not limited by the above-described materials.

A first peripheral lower insulating layer 227 and a second peripheral lower insulating layer 228 are disposed on the substrate 100. Each of the first peripheral lower insulating layer 227 and the second peripheral lower insulating layer 228 may be made of an insulating material.

A first peripheral wiring line 241a and a peripheral contact plug 241b may be disposed in the first peripheral lower insulating layer 227 and the second peripheral lower insulating layer 228. Although the first peripheral wiring line 241a and the peripheral contact plug 241b are shown as being films different from each other, the present disclosure is not limited thereto. A boundary between the first peripheral wiring line 241a and the peripheral contact plug 241b may not be distinguished. Each of the first peripheral wiring line 241a and the peripheral contact plug 241b includes a conductive material.

A first peripheral upper insulating layer 261 and a second peripheral upper insulating layer 262 may be disposed on the first peripheral wiring line 241a and the peripheral contact plug 241b. Each of the first peripheral upper insulating layer 261 and the second peripheral upper insulating layer 262 may be made of an insulating material.

A second peripheral wiring line 243 and a peripheral via plug 242 are disposed on the first peripheral wiring line 241a. The peripheral via plug 242 may be disposed in the first peripheral upper insulating layer 261. The second peripheral wiring line 243 may be disposed in the second peripheral upper insulating layer 262.

The second peripheral wiring line 243 and the peripheral via plug 242 may be connected to the first peripheral wiring line 241a. The peripheral via plug 242 may connect the first peripheral wiring line 241a with the second peripheral wiring line 243. Each of the second peripheral wiring line 243 and the peripheral via plug 242 includes a conductive material. The second peripheral wiring line 243 and the peripheral via plug 242 are shown as films different from each other, but are not limited thereto. A boundary between the second peripheral wiring line 243 and the peripheral via plug 242 may not be distinguished.

A third peripheral upper insulating layer 263, a fourth peripheral upper insulating layer 264 and a fifth peripheral upper insulating layer 265 may be sequentially disposed on the second peripheral wiring line 243. Each of the third peripheral upper insulating layer 263, the fourth peripheral upper insulating layer 264 and the fifth peripheral upper insulating layer 265 may be made of an insulating material.

The fourth peripheral upper insulating layer 264 may be made of an insulating material different from that of the third peripheral upper insulating layer 263 and the fifth peripheral upper insulating layer 265. For example, the fourth peripheral upper insulating layer 264 may be made of an oxide-based insulating material that includes silicon. The third peripheral upper insulating layer 263 and the fifth peripheral upper insulating layer 265 may be made of a nitride-based insulating material that includes silicon, but is not limited thereto.

A cell connection plug 244 may be disposed in the third peripheral upper insulating layer 263, the fourth peripheral upper insulating layer 264 and the fifth peripheral upper insulating layer 265. The cell connection plug 244 may be connected to the second peripheral wiring line 243. The cell connection plug 244 includes a conductive material. Unlike the shown example, a peripheral upper insulating layer made of a single layer may be disposed on the second peripheral wiring line 243. In this case, the cell connection plug 244 may be disposed in the upper insulating layer made of a single layer.

The bit lines BL are disposed on the peripheral gate structure PG. In more detail, the bit lines BL may be disposed on the fifth peripheral upper insulating layer 265. For example, the bit lines BL may be in contact with the fifth peripheral upper insulating layer 265.

The bit lines BL may extend lengthwise in a second direction D2. The bit lines BL adjacent to each other may be spaced apart from each other in a first direction D1. The bit line BL includes a long sidewall that extends in the second direction D2 and a short sidewall that extends in the first direction D1.

The first direction D1 and the second direction D2 may be parallel to an upper surface of the substrate 100. The first direction D1 and the second direction D2 may be horizontal directions. That is, a horizontal plane may be defined parallel to the upper surface of the substrate 100. The first direction D1 may intersect the second direction D2 (e.g. may be perpendicular to the second direction D2). A third direction D3 may be defined perpendicular to the upper surface of the substrate 100 (e.g. perpendicular to the first direction D1 and the second direction D2). The upper surface of the substrate 100 may be a surface on which the peripheral gate insulating layer 215 is located (e.g. in contact with the peripheral gate insulating layer 215). The third direction D3 may be a vertical direction. The third direction D3 may define a height direction. Accordingly, features or components that are described as being "above" other features or components may be further along the third direction D3 (e.g. further from the upper surface of the substrate 100) than the other features or components. An "upper" portion of a feature or component may be a portion that is furthest along the third direction D3. Whilst various relative directions are described herein, it will be appreciated that these directions are relative to the structure of the semiconductor device. Accordingly, these directions to not limit the orientation of the semiconductor device during use.

Although not shown, each bit line BL may extend from the cell array region to the peripheral circuit region. An end portion of each bit line BL may be disposed on the peripheral circuit region of the substrate 100.

Each bit line BL may be disposed on the cell connection plug 244. Each bit line BL may be electrically and/or physically connected to the cell connection plug 244. Each bit line BL may include at least one of, for example, a doped semiconductor material, a conductive metal nitride, a conductive metal silicon nitride, a metal carbonitride, a conductive metal silicide, a conductive metal oxide, a two-dimensional material or a metal. Each bit line BL is shown as a single layer, but is not limited thereto.

A cell lower insulating layer 171 may be disposed on the fifth peripheral upper insulating layer 265. The cell lower insulating layer 171 is disposed between the bit lines BL spaced apart from each other in the first direction D1. The cell lower insulating layer 171 may be made of an insulating material.

The protruded insulating pattern 175 may be disposed on the bit line BL and the cell lower insulating layer 171. A cell lower etch stop layer 173 may be disposed between the protruded insulating pattern 175 and the cell lower insulating layer 171. The protruded insulating pattern 175 may include portions that protrude (e.g. extend) in the third direction D3. Each portion may be located between adjacent channel gate structures AP_ST. The term "protruded" as used herein may mean extending in a particular direction (e.g. in the third direction D3).

The protruded insulating pattern 175 may include an upper protruded insulating pattern 175U and a lower protruded insulating pattern 175B. The lower protruded insulating pattern 175B may be disposed between the upper protruded insulating pattern 175U and the bit line BL and between the upper protruded insulating pattern 175U and the cell lower insulating layer 171. The lower protruded insulating pattern 175B may be disposed between the upper protruded insulating pattern 175U and the lower cell etch stop layer 173. The upper protruded insulating pattern 175U includes an upper surface of the protruded insulating pattern 175.

Each of the upper protruded insulating pattern 175U and the lower protruded insulating pattern 175B may be made of an insulating material. The upper protruded insulating pattern 175U and the lower protruded insulating pattern 175B may include their respective insulating materials different from each other. In the semiconductor memory device according to some embodiments, the upper protruded insulating pattern 175U may include a silicon nitride, and the lower protruded insulating pattern 175B may include a silicon oxide.

The cell lower etch stop layer 173 may be made of an insulating material. The cell lower etch stop layer 173 may include a material having an etch selectivity with respect to the lower protruded insulating pattern 175B. Unlike the shown example, the cell lower etch stop layer 173 may not be disposed between the lower protruded insulating pattern 175B and the cell lower insulating layer 171.

The protruded insulating pattern 175 may include a plurality of channel trenches CH_T. Each of the channel trenches CH_T may extend lengthwise in the first direction D1. The adjacent channel trenches CH_T may be spaced apart from each other in the second direction D2.

Each channel trench CH_T crosses, overlaps, or intersects the bit line BL. One channel trench CH_T may expose the plurality of bit lines BL adj acent to each other in the first direction D1.

A bottom surface of each of the channel trenches CH_T may be defined by the bit line BL and the cell lower insulating layer 171. For example, a portion of the bottom surface of the channel trench CH_T may be an upper surface BL_US of the bit line. Sidewalls of each channel trench CH_T may be defined by the lower protruded insulating pattern 175B, the upper protruded insulating pattern 175U and the cell lower etch stop layer 173. At least a portion of the sidewalls of the channel trench CH_T may be a sidewall 175SW of the protruded insulating pattern. When the cell lower etch stop layer 173 is not disposed, the sidewalls of each of the channel trenches CH_T may be defined by the lower protruded insulating pattern 175B and the upper protruded insulating pattern 175U.

A channel structure AP_ST may be disposed on each bit line BL. The plurality of channel structures AP_ST may be connected to one bit line BL. The plurality of channel structures AP_ST disposed on one bit line BL are spaced apart from each other in the second direction D2.

The channel structure AP_ST may be disposed inside the channel trench CH_T that extends in the first direction D1. A plurality of channel structures AP_ST may be disposed inside one channel trench CH_T. Each channel trench CH_T may contain a plurality of channel structures AP_ST. The plurality of channel structures AP_ST disposed inside a given channel trench CH_T are spaced apart from each other in the first direction D1.

For example, the channel structures AP_ST may be two-dimensionally disposed along the first direction D1 and the second direction D2, which cross or intersect each other.

The channel structure AP_ST may extend along the sidewalls and the bottom surface of the channel trench CH_T. In the cross-section cut in the second direction D2, the channel structures AP_ST may have a "U" shape.

The channel structure AP_ST may include a horizontal portion AP_STH, a first vertical portion AP_STV1 and a second vertical portion AP_STV2. The first vertical portion AP_STV1 of the channel structure and the second vertical portion AP_STV2 of the channel structure may protrude in the third direction D3 from the horizontal portion AP_STH of the channel structure.

The horizontal portion AP_STH of the channel structure may extend along the bottom surface of the channel trench CH_T. In the cross-section cut in the second direction D2, the horizontal portion AP_STH of the channel structure may extend along the upper surface BL_US of the bit line.

The horizontal portion AP_STH of the channel structure is connected to the bit line BL. In the semiconductor memory device according to some embodiments, the channel structure AP_ST may be in contact with the bit line BL. For example, the horizontal portion AP_STH of the channel structure may be in contact with the bit line BL.

The first vertical portion AP_STV1 of the channel structure and the second vertical portion AP_STV2 of the channel structure may extend along the sidewalls of the channel trench CH_T. The first vertical portion AP_STV1 of the channel structure and the second vertical portion AP_STV2 of the channel structure may extend along opposite sidewalls of the channel trench CH_T. In the cross-section cut in the second direction D2, the first vertical portion AP_STV1 of the channel structure and the second vertical portion AP_STV2 of the channel structure may respectively extend along the sidewalls 175SW of the protruded insulating pattern 175.

The channel structure AP_ST may include an oxide semiconductor material. The channel structure AP_ST may include, for example, a first metal oxide. The first metal oxide is a semiconductor material. For example, the channel structure AP_ST may be an amorphous metal oxide layer. For another example, the channel structure AP_ST may be a polycrystalline metal oxide layer. For another example, the channel structure AP_ST may be a combined state of an amorphous metal oxide layer and a polycrystalline metal oxide layer. For another example, the channel structure AP_ST may be a c-axis aligned crystalline (CAAC) metal oxide layer.

The channel structure AP_ST may include one of, for example, an indium oxide (In), a tin (Sn) oxide, a zinc (Zn) oxide, an In-Zn-based oxide (IZO), an Sn-Zn-based oxide, an Al-Zn-based oxide, a Zn-Mg-based oxide, an Sn-Mg-based oxide, an In-Mg-based oxide, an In-Ga-based oxide (IGO), an In-Ga-Zn-based oxide (IGZO), an In-Al-Zn-based oxide, an In-Sn-Zn-based oxide, an Sn-Ga-Zn-based oxide, an Al-Ga-Zn-based oxide, an Sn-Al-Zn-based oxide, an In-Hf-Zn-based oxide, an In-La-Zn-based oxide, an In-Ce-Zn-based oxide, an In-Pr-Zn-based oxide, an In-Nd-Zn-based oxide, an In-Sm-Zn-based oxide, an In-Eu-Zn-based oxide, an In-Gd-Zn-based oxide, an In-Tb-Zn-based oxide, an In-Dy-Zn-based oxide, an In-Ho-Zn-based oxide, an In-Er-Zn-based oxide, an In-Tm-Zn-based oxide, an In-Yb-Zn-based oxide, an In-Lu-Zn-based oxide, an In-Sn-Ga-Zn-based oxide, an In-Hf-Ga-Zn-based oxide, an In-Al-Ga-Zn-based oxide, an In-Sn-Al-Zn-based oxide, an In-Sn-Hf-Zn-based oxide or an In-Hf-Al-Zn-based oxide, but is not limited thereto.

In this case, the In-Ga-Zn-based oxide means an oxide having In, Ga and Zn as main components, but does not mean a ratio of In, Ga and Zn. That is, the channel structure AP_ST may include indium gallium zinc oxide (IGZO, InₓGa_{y}Zn_{z}O) as an example of indium gallium zinc oxide (IGZO). IGZO (In:Ga:Zn = 1:1:1) in which indium, gallium and zinc are included at the same ratio may be the In-Ga-Zn-based oxide. Ga-rich IGZO may have a gallium ratio higher than that of IGZO (In:Ga:Zn = 1:1:1) and have an indium ratio lower than that of IGZO (In:Ga:Zn = 1:1:1). The Ga-rich IGZO may be also the In-Ga-Zn-based oxide. In addition, In-rich IGZO may have an indium ratio higher than that of IGZO (In:Ga:Zn = 1:1:1) and have a gallium ratio lower than that of IGZO (In:Ga:Zn = 1:1:1). The In-rich IGZO may be also the In-Ga-Zn-based oxide.

The above description has been made using IGZO, but is not limited thereto. When each of the channel structures AP_ST includes three or more metal oxides, the above description may be applied thereto. Also, when the channel structure AP_ST includes In-Ga-Zn-based oxide, the channel structure AP_ST may further include a doped metal element in addition to In, Ga and Zn.

Each channel structure AP_ST may include a first channel pattern AP1, a second channel pattern AP2 and a connection channel pattern AP_CP. The connection channel pattern AP_CP connects the first channel pattern AP1 with the second channel pattern AP2. The first channel pattern AP1 and the second channel pattern AP2 are spaced apart from each other in the second direction D2.

The first channel pattern AP1, the second channel pattern AP2 and the connection channel pattern AP_CP are disposed on the bit line BL. The first channel pattern AP1 and the second channel pattern AP2 are connected to the bit line BL. In the semiconductor memory device according to some embodiments, the first channel pattern AP1 and the second channel pattern AP2 may be in contact with the upper surface BL_US of the bit line.

The first channel pattern AP1 may extend along the sidewalls of the channel trench CH_T. The first channel pattern AP1 may include a portion of the horizontal portion AP_STH of the channel structure and the first vertical portion AP_STV1 of the channel structure. A portion of the horizontal portion AP_STH of the channel structure may be a horizontal portion of the first channel pattern AP1. The first vertical portion AP_STV1 of the channel structure may be a vertical portion of the first channel pattern AP1.

The second channel pattern AP2 may extend along the sidewalls of the channel trench CH_T. The second channel pattern AP2 may include another portion of the horizontal portion AP_STH of the channel structure and the second vertical portion AP_STV2 of the channel structure. Another portion of the horizontal portion AP_STH of the channel structure may be a horizontal portion of the second channel pattern AP2. The second vertical portion AP_STV2 of the channel structure may be a vertical portion of the second channel pattern AP2.

The connection channel pattern AP_CP includes the rest of the horizontal portion AP_STH of the channel structure.

The first channel pattern AP1, the second channel pattern AP2 and the connection channel pattern AP_CP may be distinguished based on the first word line WL1 and the second word line WL2, which will be described later. In FIG. 4, the first word line WL1 will be described as an example. The first word line WL1 may include an inner sidewall facing the sidewall 175SW of the protruded insulating pattern and an outer sidewall opposite to the inner sidewall in the second direction D2. The boundary between the first channel pattern AP1 and the connection channel pattern AP_CP may be an extension line in which the outer sidewall of the first word line WL1 extends in the third direction D3. Accordingly, the first channel pattern AP1 may be a portion of the channel structure AP_ST that overlaps a region defined between the sidewall 175SW of the protruded insulating pattern closest to the inner sidewall of the first word line WL1 and the outer sidewall of the first word line WL1.

Each of the first channel pattern AP1, the second channel pattern AP2 and the connection channel pattern AP_CP includes the first metal oxide included in the channel structure AP_ST.

The channel interfacial layers CH_IF may be disposed between the channel structure AP_ST and the protruded insulating pattern 175. The channel interfacial layer CH_IF may be disposed between the first channel pattern AP1 and the protruded insulating pattern 175. The channel interfacial layer CH_IF may be disposed between the second channel pattern AP2 and the protruded insulating pattern 175.

The channel interfacial layer CH_IF may be in contact with the channel structure AP_ST. The channel interfacial layer CH_IF may be in contact with the first channel pattern AP1 and the second channel pattern AP2. In the semiconductor memory device according to some embodiments, the channel interfacial layer CH_IF may be in contact with the protruded insulating pattern 175. For example, the channel interfacial layer CH_IF may be in contact with the upper protruded insulating pattern 175U and/or the lower protruded insulating pattern 175B.

The channel interfacial layer CH_IF may extend along the sidewalls of the channel trench CH_T. In the semiconductor memory device according to some embodiments, the channel interfacial layer CH_IF may not extend along the upper surface BL_US of the bit line. In other words, the channel interfacial layer CH_IF may not extend along the bottom surface of the channel trench CH_T. That is, the channel interfacial layer CH_IF may include only a vertical portion CH_IFV of the channel interfacial layer.

The channel interfacial layer CH_IF may extend to the bit line BL. The channel interfacial layer CH_IF may be in contact with the bit line BL. For example, the channel interfacial layer CH_IF may be in contact with the upper surface BL_US of the bit line.

The channel interfacial layer CH_IF may include at least one of a silicon oxide, a silicon oxynitride, a silicon nitride or a metal oxide. When the channel interfacial layer CH_IF includes a metal oxide, the channel interfacial layer CH_IF may include a second metal oxide different from the first metal oxide included in the channel structure AP_ST. The second metal oxide may be an insulating material, unlike the first metal oxide. The second metal oxide may include at least one of, for example, an aluminum oxide or a hafnium oxide, but the scope of the present disclosure is not limited thereto. That is, the channel interfacial layer CH_IF may include a metal oxide that is an insulating material.

For example, when the channel interfacial layer CH_IF includes the same material as that of the upper protruded insulating pattern 175U, a boundary between the channel interfacial layer CH_IF and the upper protruded insulating pattern 175U may not be distinguished. The boundary between the channel interfacial layer CH_IF and the upper protruded insulating pattern 175U may be identified using the boundary between the channel interfacial layer CH_IF and the lower protruded insulating pattern 175B.

In addition, when a boundary between the channel interfacial layer CH_IF and the cell lower etch stop layer 173 is not distinguished, the boundary between the channel interfacial layer CH_IF and the cell lower etch stop layer 173 may be also identified using the boundary between the channel interfacial layer CH_IF and the lower protruded insulating pattern 175B.

For another example, when the channel interfacial layer CH_IF includes the same material as that of the lower protruded insulating pattern 175B, the boundary between the channel interfacial layer CH_IF and the lower protruded insulating pattern 175B may not be distinguished. The boundary between the channel interfacial layer CH_IF and the lower protruded insulating pattern 175B may be identified using the boundary between the channel interfacial layer CH_IF and the upper protruded insulating pattern 175U.

When the channel structure AP_ST and the protruded insulating pattern 175 are in contact with each other, electrical characteristics of the semiconductor memory device may be deteriorated. As the channel interfacial layer CH_IF is inserted between the channel structure AP_ST and the protruded insulating pattern 175, interface characteristics of the channel structure AP_ST may be improved. As a result, subthreshold swing (SS) and current characteristics of the semiconductor memory device may be improved.

In addition, a border trap may be distributed in the protruded insulating pattern 175. Due to the border trap, a threshold voltage Vₜₕ fluctuation of a random noise telegraph may be generated so that reliability of the semiconductor memory device may be deteriorated. The channel interfacial layer CH_IF is inserted between the channel structure AP_ST and the protruded insulating pattern 175, whereby the threshold voltage fluctuation of the semiconductor memory device may be improved.

The first word line WL1 and the second word line WL2 may be disposed on the channel structure AP_ST. The first word line WL1 and the second word line WL2 may be disposed inside the channel trench CH_T.

Each of the first word line WL1 and the second word line WL2 may extend in the first direction D1. The first word line WL1 and the second word line WL2 may be alternately arranged in the second direction D2. The first word line WL1 is spaced apart from the second word line WL2 in the second direction D2.

The first word line WL1 and the second word line WL2 are spaced apart from the bit line BL in the third direction D3. The first word line WL1 and the second word line WL2 cross the bit line BL.

The first word line WL1 and the second word line WL2 are disposed on the horizontal portion AP_STH of the channel structure. The first word line WL1 and the second word line WL2 are disposed between the first vertical portion AP_STV1 of the channel structure and the second vertical portion AP_STV2 of the channel structure.

The first word line WL1 is disposed on the first channel pattern AP1. The second word line WL2 is disposed on the second channel pattern AP2. The first word line WL1 and the second word line WL2 are disposed between the first channel pattern AP1 and the second channel pattern AP2. The first channel pattern AP1 is closer to the first word line WL1 than the second word line WL2. The second channel pattern AP2 is closer to the second word line WL2 than the first word line WL1.

Each of the first word line WL1 and the second word line WL2 may have a width in the second direction D2. The width of the first word line WL1 in a portion overlapped with the channel structure AP_ST in the third direction D3 may be different from that of the first word line WL1 in a portion that is not overlapped with the channel structure AP_ST. The width of the second word line WL2 in a portion overlapped with the channel structure AP_ST in the third direction D3 may be different from that of the second word line WL2 in a portion that is not overlapped with the channel structure AP_ST.

For example, each of the first word line WL1 and the second word line WL2 may include a first portion WLa of the word line and a second portion WLb of the word line. A width of the first portion WLa of the word line in the second direction D2 may be smaller than that of the second portion WLb of the word line in the second direction D2. For example, the first portion WLa of the word line may be disposed on the channel structure AP_ST. The first portion WLa of the word line may be disposed on the first channel pattern AP1 and the second channel pattern AP2.

Each of the first word line WL1 and the second word line WL2 may include a first portion WLa of the word line and a second portion WLb of the word line, which are alternately disposed along the first direction D1. Each of the channel structures AP_ST may be disposed between the second portions WLb of the word lines adjacent to each other in the first direction D1. In the first word line WL1, each of the first channel patterns AP1 may be disposed between the second portions WLb of the word lines adjacent to each other in the first direction D1. In the second word line WL2, each of the second channel patterns AP2 may be disposed between the second portions of the word lines adjacent to each other in the first direction D1.

The channel structure AP_ST is not disposed below the second portion WLb of the word line. A height of the first portion WLa of the word line is smaller than that of the second portion WLb of the word line. For example, a difference in height between the first portion WLa of the word line and the second portion WLb of the word line may be the same as a thickness of the channel structure AP_ST.

The first word line WL1 and the second word line WL2 include a conductive material, and may include at least one of, for example, a doped polysilicon, a conductive metal nitride, a conductive metal silicon nitride, a metal carbonitride, a conductive metal silicide, a conductive metal oxide, a two-dimensional material, a metal or a metal alloy.

Each of the first word line WL1 and the second word line WL2 may include an upper surface WL_US and a bottom surface WL_BS, which are opposite to each other in the third direction D3. The bottom surface of the first word line WL1 and the bottom surface of the second word line WL2 face (i.e., are parallel to) the upper surface BL_US of the bit line.

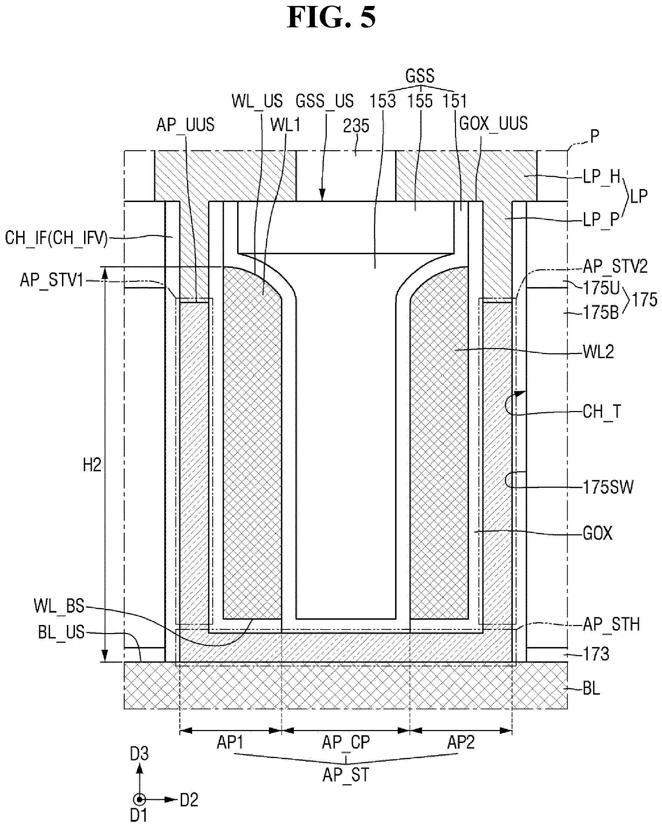

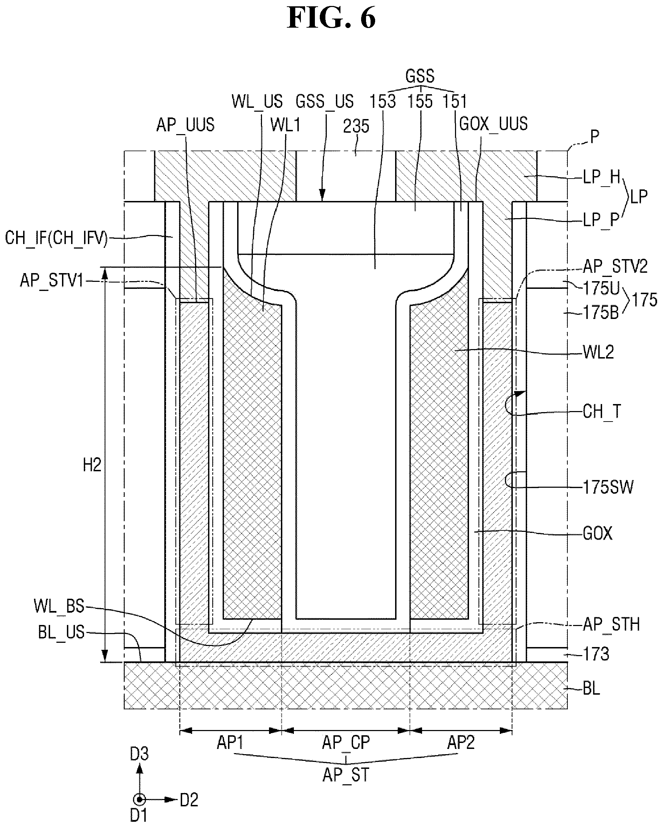

In FIG. 4, the upper surface WL_US of the first and second word lines WL1 and WL2 may be planar. In FIG. 5, the upper surface WL_US of the first and second word lines WL1 and WL2 may be convexly rounded. In FIG. 6, the upper surface WL_US of the first and second word lines WL1 and WL2 may be concavely rounded.

The upper surface WL_US of the first and second word lines WL1 and WL2 may be higher than an uppermost portion AP_UUS of the vertical portions AP_STV1 and AP_STV2 of the channel structure, relative to the upper surface BL_US of the bit line. The uppermost portion of the channel patterns AP1 and AP2 may be the uppermost portion AP_UUS of the vertical portions AP_STV1 and AP_STV2 of the channel structure. A height H1 from the upper surface BL_US of the bit line to the uppermost portion AP_UUS of the vertical portions AP_STV1 and AP_STV2 of the channel structure may be smaller than a height H2 from the upper surface BL_US of the bit line to the upper surface WL_US of the first and second word lines WL1 and WL2.

The uppermost portion AP_UUS of the channel structure is lower than the upper surface of the protruded insulating pattern 175 relative to the upper surface BL_US of the bit line.

A gate insulating layer GOX may be disposed between the first word line WL1 and the channel structure AP_ST and between the second word line WL2 and the channel structure AP_ST. The gate insulating layer GOX may be disposed between the first word line WL1 and the first channel pattern AP1 and between the second word line WL2 and the second channel patterns AP2. The gate insulating layer GOX may extend in the first direction D1 in parallel with the first word line WL1 and the second word line WL2.

The gate insulating layer GOX may extend along the first vertical portion AP_STV1 of the channel structure. The gate insulating layer GOX may extend along the second vertical portion AP_STV2 of the channel structure. In the semiconductor memory device according to some embodiments, the gate insulating layer GOX may not be disposed on the horizontal portion AP_STH of the channel structure that does not overlap the first word line WL1 and the second word line WL2 in the third direction D3 (e.g. may not be disposed on the connection channel pattern AP_CP). In the cross-sectional view, the gate insulating layer GOX between the first word line WL1 and the channel structure AP_ST may be separated from the gate insulating layer GOX between the second word line WL2 and the channel structure AP_ST.

The gate insulating layer GOX may include a silicon oxide layer, a silicon oxynitride layer, a high dielectric constant insulating layer having a dielectric constant higher than that of the silicon oxide layer or their combination.

A portion of the gate insulating layer GOX may be more protruded (e.g. may extend further) in the third direction D3 than the upper surface WL_US of the first and second word lines WL1 and WL2. A portion of the gate insulating layer GOX may be more protruded in the third direction D3 than the uppermost portion AP_UUS of the vertical portions AP_STV1 and AP_STV2 of the channel structure.

A height H4 from the upper surface BL_US of the bit line to an uppermost portion GOX_UUS of the gate insulating layer may be greater than the height H1 from the upper surface BL_US of the bit line to the uppermost portion AP_UUS of the vertical portions AP_STV1 and AP_STV2 of the channel structure. The height H4 from the upper surface BL_US of the bit line to the uppermost portion GOX_UUS of the gate insulating layer may be greater than the height H2 from the upper surface of the bit line BL to the upper surface WL_US of the word lines WL1 and WL2.

A gate isolation pattern GSS may be disposed on the bit line BL and the cell lower insulating layer 171. The gate isolation pattern GSS may be disposed inside the channel trench CH_T. The gate isolation pattern GSS may be disposed on the channel structure AP_ST, the first word line WL1 and the second word line WL2.

In the semiconductor memory device according to some embodiments, the gate isolation pattern GSS may be in contact with the channel structure AP_ST. The gate isolation pattern GSS may be disposed on the connection channel pattern AP_CP. The gate isolation pattern GSS may be in contact with the horizontal portion AP_STH of the channel structure. The gate isolation pattern GSS may be spaced apart from the bit line BL in the third direction D3.

The gate isolation pattern GSS may be disposed between the first word line WL1 and the second word line WL2, which are adjacent to each other in the second direction D2. The first word line WL1 and the second word line WL2 may be separated from each other by the gate isolation pattern GSS. The gate isolation pattern GSS may extend in the first direction D1 between the first word line WL1 and the second word line WL2.

The first word line WL1 may be disposed between the gate isolation pattern GSS and the channel structure AP_ST. The second word line WL2 may be disposed between the gate isolation pattern GSS and the channel structure AP_ST. The first word line WL1 may be disposed between the gate isolation pattern GSS and the first channel pattern AP1. The second word line WL2 may be disposed between the gate isolation pattern GSS and the second channel pattern AP2.

The gate isolation pattern GSS may include a horizontal portion and a protrusion portion. The protrusion portion of the gate isolation pattern GSS may be protruded (e.g. may extend) in a direction opposite to the third direction D3 from the horizontal portion of the gate isolation pattern GSS toward the bit line BL. The protrusion portion of the gate isolation pattern GSS may be closer to the bit line BL than the horizontal portion of the gate isolation pattern GSS. The horizontal portion of the gate isolation pattern GSS may be disposed on the upper surface WL_US of the first and second word lines WL1 and WL2. The gate isolation pattern may have a "T" shape in view of the cross-sectional view.

The gate isolation pattern GSS may include a gate isolation liner 151, a gate isolation filling layer 153 and a gate isolation capping layer 155. The gate isolation liner 151 may extend along the upper surface WL_US of the first and second word lines WL1 and WL2 and the outer sidewalls of the first and second word lines WL1 and WL2. The gate isolation liner 151 may extend along the horizontal portion AP_STH of the channel structure. The gate isolation liner 151 may be in contact with the connection channel pattern AP_CP. The gate isolation liner 151 may extend along the gate insulating layer GOX that is more protruded than (e.g. that extends beyond) the upper surface WL_US of the first and second word lines WL1 and WL2. The gate isolation liner 151 may be in contact with sides of the gate insulating layer GOX. Unlike the shown example, in some embodiments, the gate isolation liner 151 may not extend along the gate insulating layer GOX more protruded than the upper surface WL_US of the first and second word lines WL1 and WL2.

The gate isolation filling layer 153 may be disposed on the gate isolation liner 151. The gate isolation capping layer 155 may be disposed on the gate isolation filling layer 153. Each of the gate isolation liner 151, the gate isolation filling layer 153 and the gate isolation capping layer 155 may be made of an insulating material. For example, the gate isolation liner 151 and the gate isolation capping layer 155 may be made of a nitride-based insulating material containing silicon, and the gate isolation filling layer 153 may be made of an oxide-based insulating material containing silicon, but is not limited thereto. Unlike the shown example, the gate isolation pattern GSS may be a single layer.

An upper surface GSS_US of the gate isolation pattern may be disposed at the same height as the upper surface of the protruded insulating pattern 175 relative to the upper surface BL_US of the bit line, but is not limited thereto.

A height H3 from the upper surface BL_US of the bit line to the upper surface GSS_US of the gate isolation pattern may be greater than the height H1 from the upper surface BL_US of the bit line to the uppermost portion AP_UUS of the vertical portions AP_STV1 and AP_STV2 of the channel structure. The height H3 from the upper surface BL_US of the bit line to the upper surface GSS_US of the gate isolation pattern may be greater than the height H2 from the upper surface BL_US of the bit line to the upper surface WL_US of the word lines WL1 and WL2.

The height H3 from the upper surface BL_US of the bit line to the upper surface GSS_US of the gate isolation pattern is shown as being equal to the height H4 from the upper surface BL_US of the bit line to the uppermost portion GOX_UUS of the gate insulating layer, but is not limited thereto.

Landing pads LP may be disposed on the channel structure AP_ST. The landing pads LP are connected to the first vertical portion AP_STV1 of the channel structure and the second vertical portion AP_STV2 of the channel structure.

The landing pads LP may be disposed on the first channel pattern AP1 and the second channel pattern AP2. The landing pads LP are connected to the first channel pattern AP1 and the second channel pattern AP2.

When viewed in a plan view, the landing pads LP may have various shapes such as a circular shape, an oval shape, a rectangular shape, a square shape, a rhombus shape and a hexagonal shape.

The landing pad LP may include a horizontal portion LP_H and a protrusion LP_P. The horizontal portion LP_H of the landing pad may be disposed on the upper surface of the protruded insulating pattern 175 and the upper surface GSS_US of the gate isolation pattern. The protrusion portion LP_P of the landing pad may be protruded in the third direction D3 from the horizontal portion LP_H of the landing pad toward the bit line BL.

A lowermost portion of the landing pattern LP may be lower than the upper surface GSS_US of the gate isolation pattern relative to the upper surface BL_US of the bit line. In other words, the protrusion portion LP_P of the landing pad is disposed between the protruded insulating pattern 175 and the gate isolation pattern GSS. A height from the upper surface BL_US of the bit line to the lowermost portion of the landing pattern LP may be smaller than the height H4 from the upper surface of the bit line BL to the uppermost portion GOX_UUS of the gate insulating layer.

The pad isolation insulating patterns 235 may be disposed between the landing pads LP. When viewed in a plan view, the landing pads LP may be arranged in the form of a matrix along the first direction D1 and the second direction D2. An upper surface of the landing pad LP may be disposed on the same plane as the upper surface of the pad isolation insulating pattern 235, but is not limited thereto.

The landing pad LP includes a conductive material. The landing pad LP may include at least one of, for example, a doped polysilicon, a conductive metal nitride, a conductive metal silicon nitride, a metal carbonitride, a conductive metal silicide, a conductive metal oxide, a two-dimensional material, a metal or a metal alloy.

The data storage patterns DSP may be disposed on the landing pads LP, respectively. The data storage patterns DSP may be connected to the first vertical portion AP_STV1 of the channel structure and the second vertical portion AP_STV2 of the channel structure. The data storage patterns DSP may be connected to the first and second channel patterns AP1 and AP2, respectively.

As shown in FIG. 1, the data storage patterns DSP may be arranged in the form of a matrix along the first direction D1 and the second direction D2. The data storage patterns DSP may completely or partially overlap the landing pads LP in the third direction D3. The data storage patterns DSP may be in contact with all or some of the upper surface of the landing pads LP.

For example, the data storage patterns DSP may be capacitors. The first channel pattern AP1 may be connected to a first capacitor. The second channel pattern AP2 may be connected to a second capacitor.

The data storage patterns DSP may include a capacitor dielectric layer 253 interposed between storage electrodes 251 and a plate electrode 255. In this case, the storage electrode 251 may be in contact with the landing pad LP. When viewed in a plan view, the storage electrode 251 may have various shapes such as a circular shape, an oval shape, a rectangular shape, a square shape, a rhombus shape or a hexagonal shape. The data storage patterns DSP may completely or partially overlap the landing pads LP. The data storage patterns DSP may be in contact with all or some of the upper surface of the landing pads LP. The storage electrodes 251 may pass through, penetrate, or extend into the cell upper etch stop layer 247. The cell upper etch stop layer 247 may be made of an insulating material.

Each of the storage electrode 251 and the plate electrode 255 may include at least one of, for example, a conductive semiconductor material, a conductive metal nitride, a conductive metal silicon nitride, a metal carbonitride, a conductive metal silicide, a conductive metal oxide or a metal. The capacitor dielectric layer 253 may include at least one of a ferroelectric material, an antiferroelectric material or a paraelectric material. For example, the capacitor dielectric layer 253 may include one of a ferroelectric material, an antiferroelectric material, a paraelectric material, combination of a ferroelectric material and an antiferroelectric material, combination of a ferroelectric material and a paraelectric material, combination of a paraelectric material and an antiferroelectric material, and combination of a ferroelectric material, an antiferroelectric material and/or a paraelectric material.

In some embodiments, the data storage patterns DSP may be variable resistance patterns that may be switched between two resistance states by an electrical pulse applied to a memory element. For example, the data storage patterns DSP may include a phase-change material in which a crystal state is changed in accordance with the amount of current, perovskite compounds, a transition metal oxide, magnetic materials, ferromagnetic materials or antiferromagnetic materials.

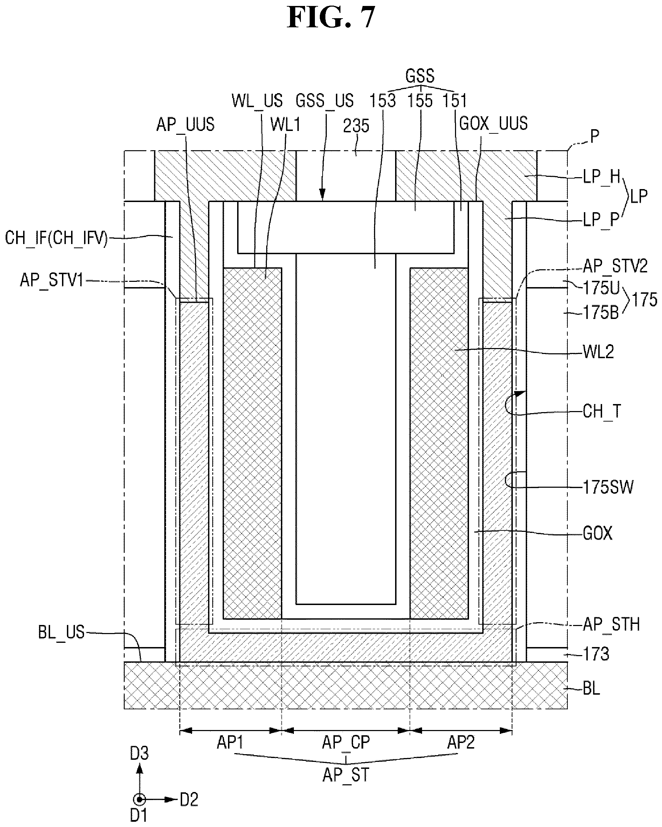

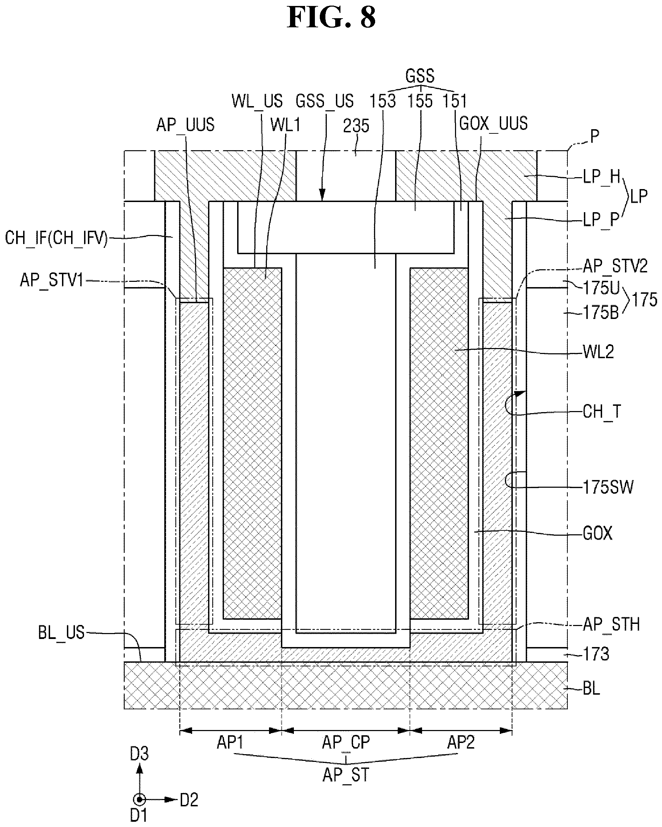

FIG. 7 is a view illustrating a semiconductor memory device according to some embodiments. FIG. 8 is a view illustrating a semiconductor memory device according to some embodiments. For convenience of description, the following description will be based on differences from the description made with reference to FIGS. 1 to 6. For reference, FIGS. 7 and 8 are enlarged views illustrating a portion P of FIG. 2.

Referring to FIG. 7, in the semiconductor memory device according to some embodiments, the gate isolation pattern GSS is not in contact with the channel structure AP_ST.

A portion of the gate insulating layer GOX may be disposed between the gate isolation pattern GSS and the channel structure AP_ST. In the cross-sectional view, the gate insulating layer GOX between the first word line WL1 and the channel structure AP_ST may be connected to the gate insulating layer GOX between the second word line WL2 and the channel structure AP_ST.

Referring to FIG. 8, in the semiconductor memory device according to some embodiments, a portion of the gate isolation pattern GSS may be recessed into the channel structure AP_ST.

A thickness of the connection channel pattern AP_CP is smaller than that of the horizontal portion AP_STH of the channel structure included in the channel patterns AP 1 and AP2.

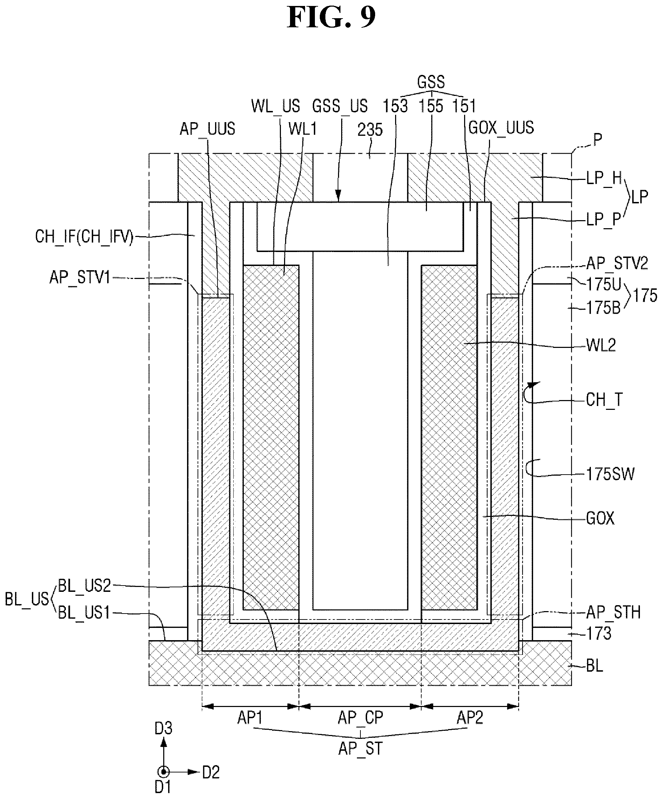

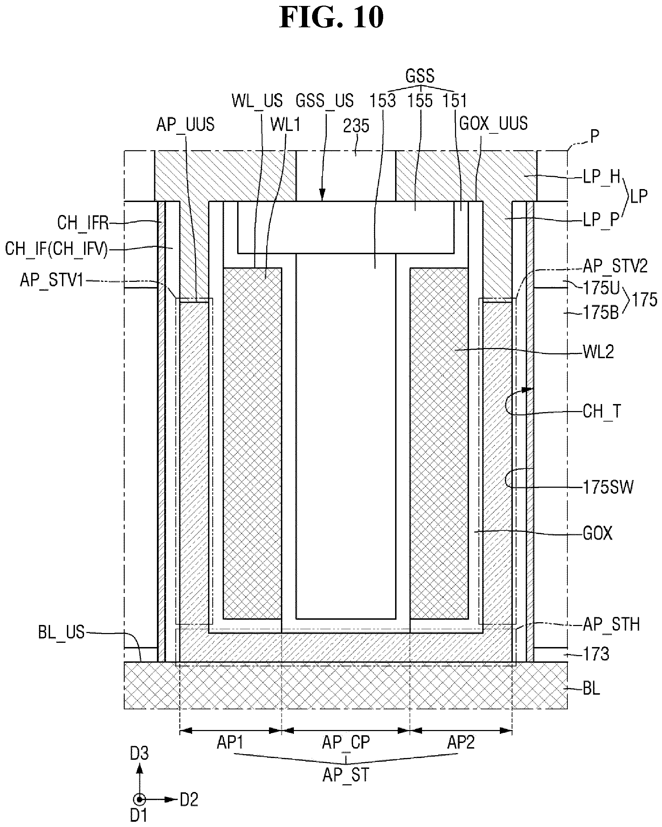

FIG. 9 is a view illustrating a semiconductor memory device according to some embodiments. FIG. 10 is a view illustrating a semiconductor memory device according to some embodiments. For convenience of description, the following description will be based on differences from the description made with reference to FIGS. 1 to 6. For reference, FIGS. 9 and 10 are enlarged views illustrating a portion P of FIG. 2.

Referring to FIG. 9, in the semiconductor memory device according to some embodiments, the upper surface BL_US of the bit line may include a first region BL_US1 and a second region BL_US2.

The protruded insulating pattern 175 may be disposed on the first region BL_US1 of the upper surface of the bit line. The protruded insulating pattern 175 may overlap the first region BL_US1 of the upper surface of the bit line in the third direction D3. The channel interfacial layer CH_IF may be disposed on the first region BL_US1 of the upper surface of the bit line. The channel interfacial layer CH_IF may be in contact with the first region BL_US1 of the upper surface of the bit line.

The channel structures AP_ST may be disposed on the second region BL_US2 of the upper surface of the bit line. The first channel pattern AP1 and the second channel pattern AP2 may be disposed on the second region BL_US2 of the upper surface of the bit line. The second region BL_US2 of the upper surface of the bit line may be the bottom surface of the channel trench CH_T. For example, the channel structure AP_ST may be in contact with the second region BL_US2 of the upper surface of the bit line.

A height of the first region BL_US1 of the upper surface of the bit line may be different from that of the second region BL_US2 of the upper surface of the bit line. Relative to the upper surface of the substrate (100 of FIG. 2), the second region BL_US2 of the upper surface of the bit line may be lower than the first region BL_US1 of the upper surface of the bit line.

Referring to FIG. 10, the semiconductor memory device according to some embodiments may further include an interface insertion layer CH_IFR disposed between the protruded insulating pattern 175 and the channel interfacial layer CH_IF.

The interface insertion layer CH_IFR may extend along the channel interfacial layer CH_IF. The interface insertion layer CH_IFR may be in contact with the upper surface BL_US of the bit line. The interface insertion layer CH_IFR may be a material layer remaining without being oxidized while the channel interfacial layer CH_IF is being formed.

The interface insertion layer CH_IFR may include, for example, a semiconductor material. When the interface insertion layer CH_IFR is disposed, the channel interfacial layer CH_IF may include at least one of a silicon oxide, a silicon oxynitride or a silicon nitride.

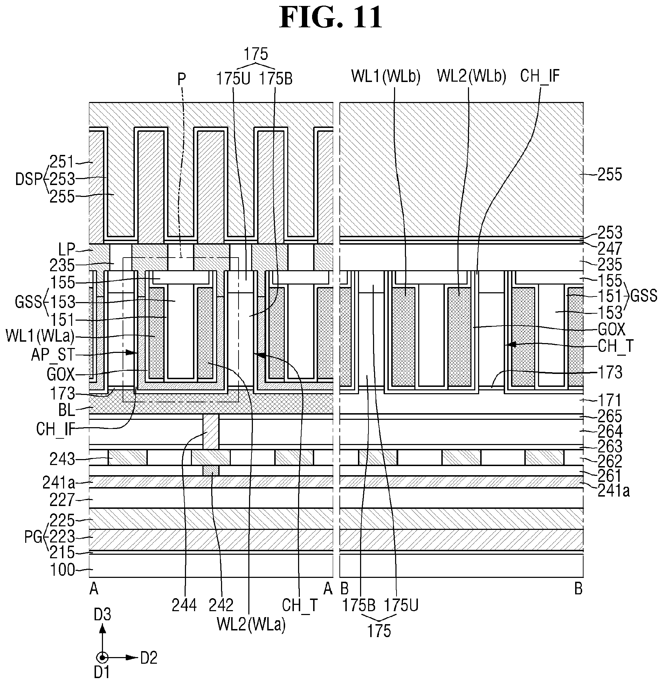

FIGS. 11 to 13 are views illustrating a semiconductor memory device according to some embodiments. For convenience of description, the following description will be based on differences from the description made with reference to FIGS. 1 to 6.

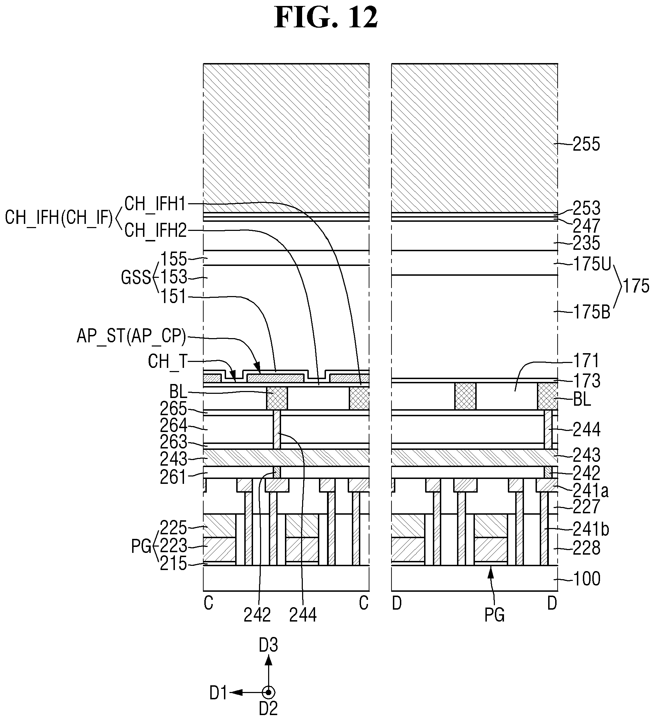

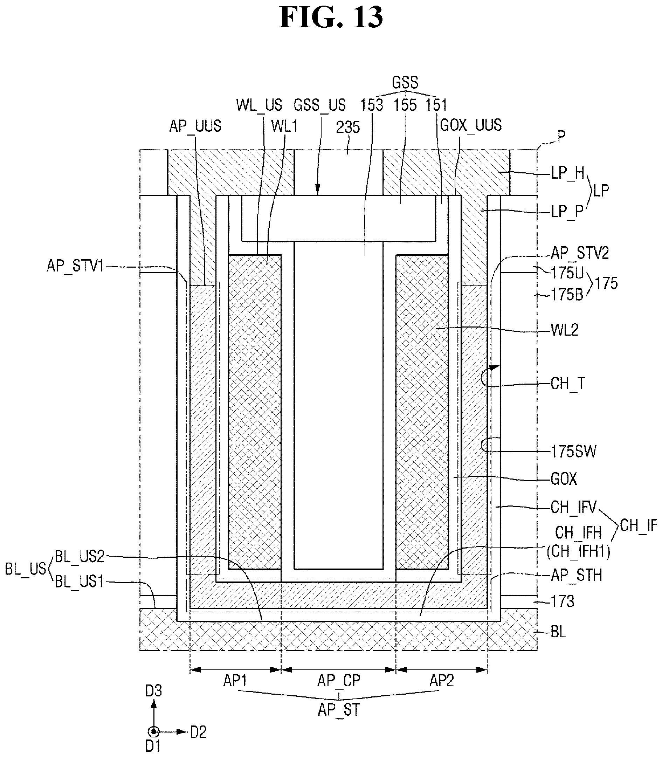

For reference, FIG. 11 is a cross-sectional view taken along lines A-A and B-B of FIG. 1. FIG. 12 is a cross-sectional view taken along lines C-C and D-D of FIG. 1. FIG. 13 is an enlarged view illustrating a portion P of FIG. 11.

Referring to FIGS. 11 to 13, in the semiconductor memory device according to some embodiments, the channel interfacial layer CH_IF may extend along the sidewalls and the bottom surface of the channel trench CH_T.

The channel interfacial layer CH_IF may be disposed between the channel structure AP_ST and the protruded insulating pattern 175 and between the channel structure AP_ST and the bit line BL. The channel interfacial layer CH_IF may be disposed between the channel structure AP_ST and the cell lower insulating layer 171.

The channel interfacial layer CH_IF may include vertical portions CH_IFV that extend along the sidewalls of the channel trench CH_T and a horizontal portion CH_IFH that extends along the bottom surface of the channel trench CH_T. The vertical portions CH_IFV of the channel interfacial layer may protrude in the third direction D3 from the horizontal portion CH_IFH of the channel interfacial layer. A first vertical portion CH_IFV may extend along a first sidewall of the channel trench CH_T and a second vertical portion CH_IFV may extend along a second sidewall of the channel trench CH_T, wherein the second sidewall is opposite to the first sidewall.

The vertical portion CH_IFV of the channel interfacial layer may be disposed between the channel structure AP_ST and the protruded insulating pattern 175. The horizontal portion CH_IFH of the channel interfacial layer may be disposed between the channel structure AP_ST and the bit line BL and between the channel structure AP_ST and the cell lower insulating layer 171.

The horizontal portion CH_IFH of the channel interfacial layer may be in contact with the bit line BL. Since the channel interfacial layer CH_IF is disposed between the channel structure AP_ST and the bit line BL, the channel structure AP_ST may not be in contact with the bit line BL.

The horizontal portion CH_IFH of the channel interfacial layer may include a first portion CH_IFH1 and a second portion CH_IFH2. The first portion CH_IFH1 of the horizontal portion of the channel interfacial layer may be in contact with the bit line BL. The second portion CH_IFH2 of the horizontal portion of the channel interfacial layer may be in contact with the cell lower insulating layer 171.

The horizontal portion CH_IFH of the channel interfacial layer may include a material different from that of the vertical portion CH_IFV of the channel interfacial layer. The vertical portion CH_IFV of the channel interfacial layer may include at least one of, for example, a silicon oxynitride or a silicon nitride.

The first portion CH_IFH1 of the horizontal portion of the channel interfacial layer may include a material different from that of the second portion CH_IFH2 of the horizontal portion of the channel interfacial layer. The second portion CH_IFH2 of the horizontal portion of the channel interfacial layer may include at least one of, for example, a silicon oxynitride or a silicon nitride. The first portion CH_IFH1 of the horizontal portion of the channel interfacial layer may include, for example, a metal nitride. When the bit line BL includes a first metal, the metal nitride included in the first portion CH_IFH1 of the horizontal portion of the channel interfacial layer may be the nitride of the first metal included in the bit line BL. When it is assumed that the bit line BL includes tungsten (W), the first portion CH_IFH1 of the horizontal portion of the channel interfacial layer may include a tungsten nitride.

For example, when the second portion CH_IFH2 of the horizontal portion of the channel interfacial layer includes the same material as that of the cell lower insulating layer 171, the second portion CH_IFH2 of the horizontal portion of the channel interfacial layer may not be distinguished from the cell lower insulating layer 171. A boundary between the cell lower insulating layer 171 and the second portion CH_IFH2 of the horizontal portion of the channel interfacial layer may be identified using the boundary between the bit line BL and the first portion CH_IFH1 of the horizontal portion of the channel interfacial layer.

The upper surface BL_US of the bit line may include a first region BL_US1 and a second region BL_US2. The protruded insulating pattern 175 may be disposed on the first region BL_US1 of the upper surface of the bit line. The channel interfacial layer CH_IF may be disposed on the second region BL_US2 of the upper surface of the bit line. The channel interfacial layer CH_IF may extend along the second region BL_US2 of the upper surface of the bit line.

The second region BL_US2 of the upper surface of the bit line may be lower than the first region BL_US1 of the upper surface of the bit line relative to the upper surface of the substrate (100 of FIG. 2).

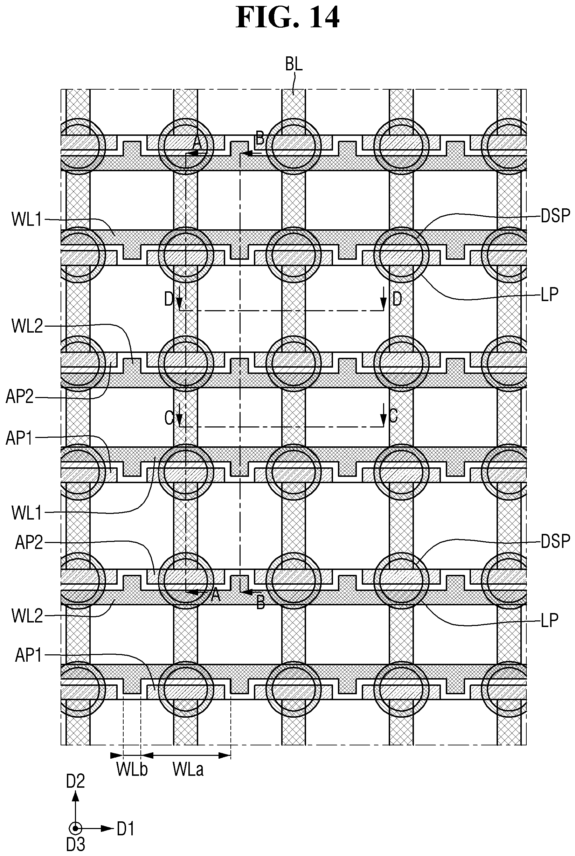

FIGS. 14 to 17 are views illustrating a semiconductor memory device according to some embodiments. For convenience of description, the following description will be based on differences from the description made with reference to FIGS. 1 to 6.

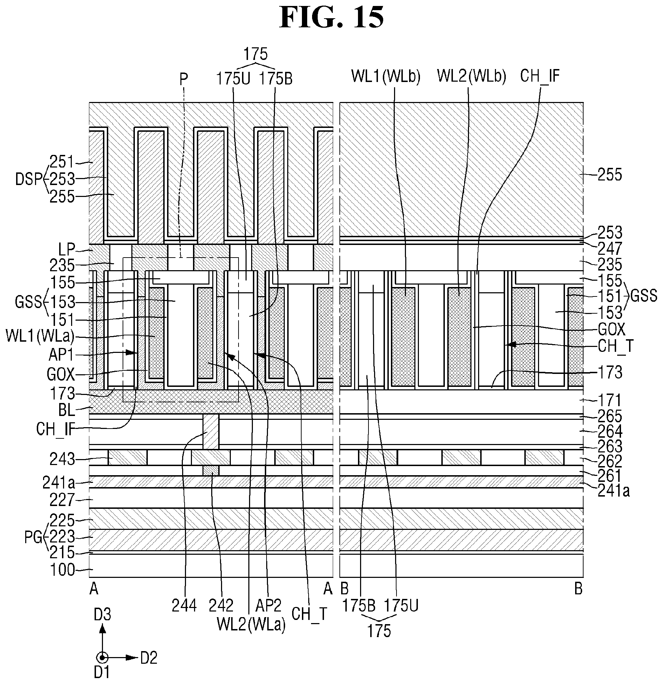

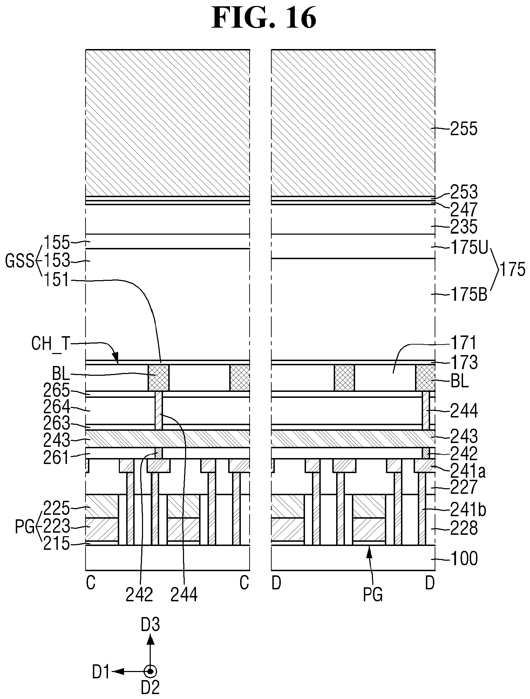

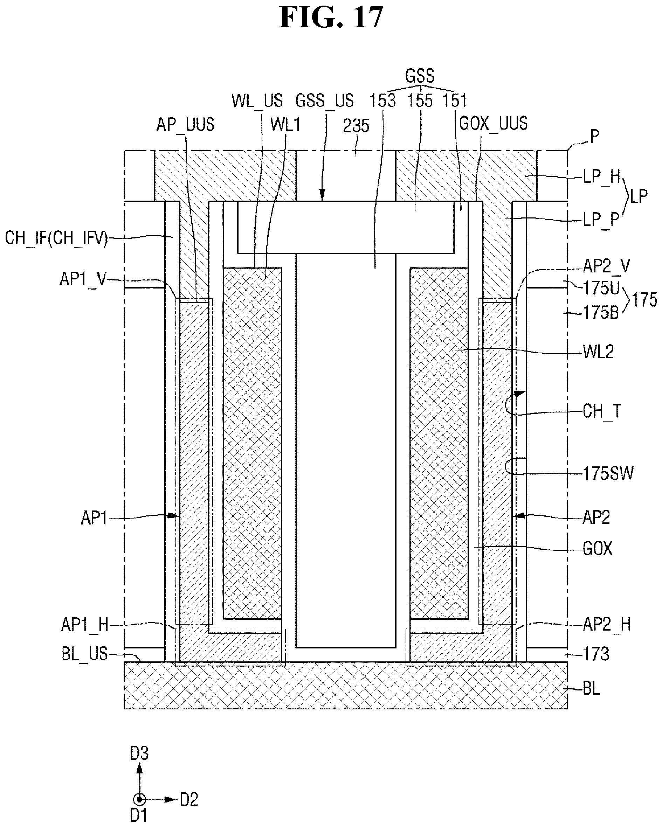

For reference, FIG. 14 is a layout view illustrating a semiconductor memory device according to some embodiments. FIG. 15 is a cross-sectional view taken along lines A-A and B-B of FIG. 14. FIG. 16 is a cross-sectional view taken along lines C-C and D-D of FIG. 14. FIG. 17 is an enlarged view illustrating a portion P of FIG. 15.

Referring to FIGS. 14 to 17, in the semiconductor memory device according to some embodiments, the first channel pattern AP1 and the second channel pattern AP2, which are spaced apart from each other in the second direction D2, are not connected to each other inside the channel trench CH_T.

The first channel pattern AP1 may include a horizontal portion AP1_H that extends along the upper surface BL_US of the bit line and a vertical portion AP1_V that extends along the sidewall 175SW of the protruded insulating pattern. The vertical portion AP1_V of the first channel pattern may be protruded in the third direction D3 from the horizontal portion AP1_H of the first channel pattern.

The second channel pattern AP2 may include a horizontal portion AP2_H that extends along the upper surface BL_US of the bit line and a vertical portion AP2_V that extends along the sidewall 175SW of the protruded insulating pattern. The vertical portion AP2_V of the second channel pattern may be protruded in the third direction D3 from the horizontal portion AP2_H of the second channel pattern.

The gate isolation pattern GSS may be in contact with the bit line BL. The horizontal portion AP1_H of the first channel pattern and the horizontal portion AP2_H of the second channel pattern may be spatially separated from each other by the gate isolation pattern GSS. The gate isolation liner 151 may be in contact with the bit line BL.

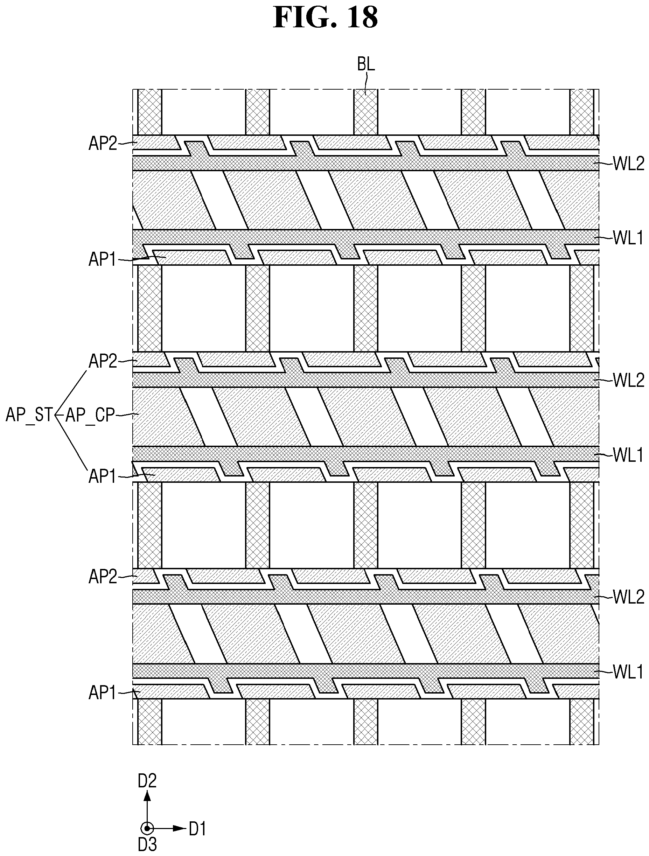

FIGS. 18 to 21 are views illustrating a semiconductor memory device according to some embodiments. For convenience of description, the following description will be based on differences from the description made with reference to FIGS. 1 to 6.

Referring to FIG. 18, in the semiconductor memory device according to some embodiments, the first channel pattern AP1 and the second channel pattern AP2 may be alternately arranged in a diagonal direction with respect to the first direction D1 and the second direction D2. In this case, the diagonal direction may be parallel with the upper surface of the substrate (100 of FIG. 2).

The channel structure AP_ST may be formed to be twisted in the diagonal direction. Within each channel structure AP_ST, the connection channel pattern AP_CP may extend in the diagonal direction. When viewed in a plan view, each of the first channel pattern AP1, the second channel pattern AP2 and the connection channel pattern AP_CP may have a parallelogram shape or a rhombus shape.

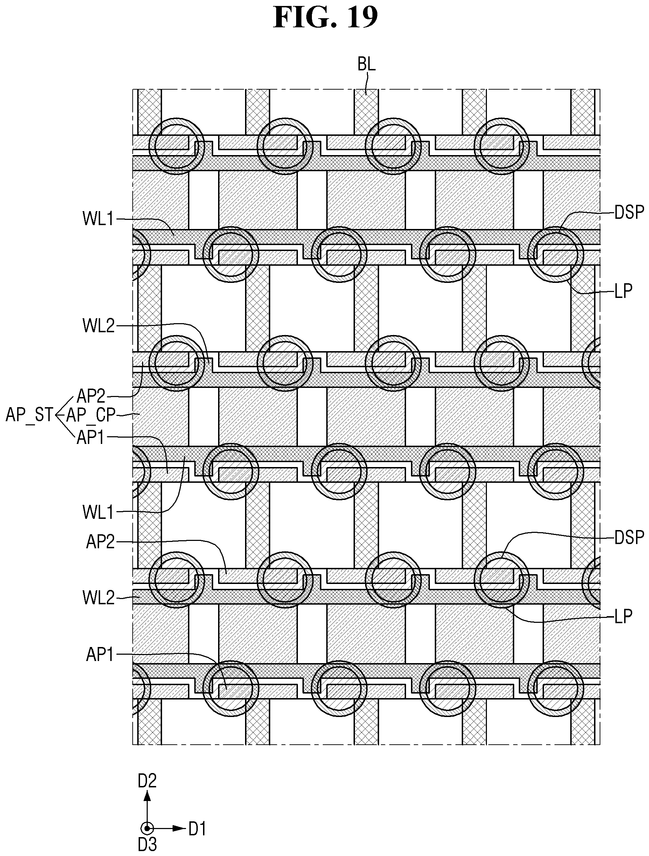

Referring to FIG. 19, in the semiconductor memory device according to some embodiments, the landing pads LP and the data storage patterns DSP may be arranged in a zigzag shape or a honeycomb shape when viewed in a plan view.

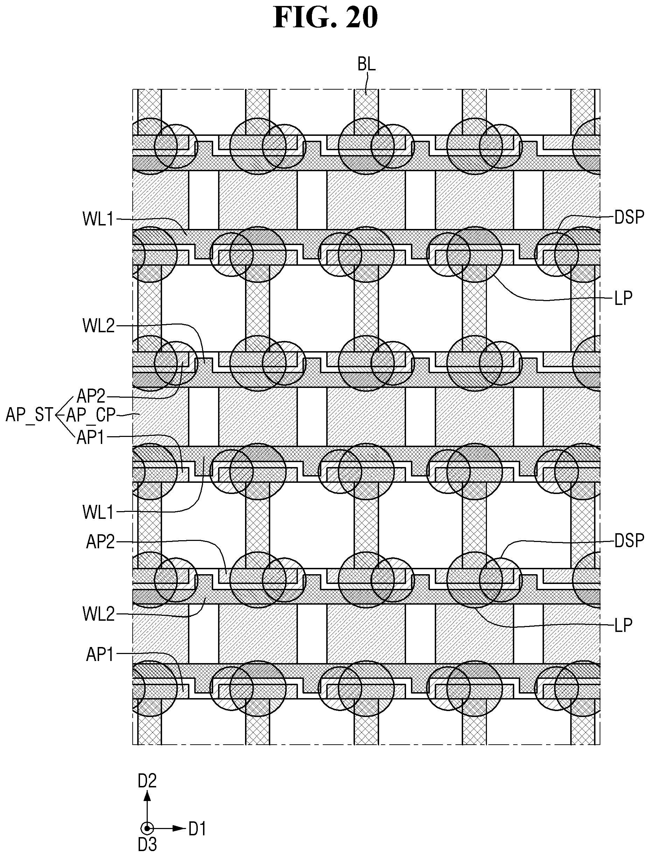

Referring to FIG. 20, in the semiconductor memory device according to some embodiments, the data storage patterns DSP may be disposed to be misaligned with the landing pads LP when viewed in a plan view.

Each of the data storage patterns DSP may be in contact with a portion of the landing pads LP.

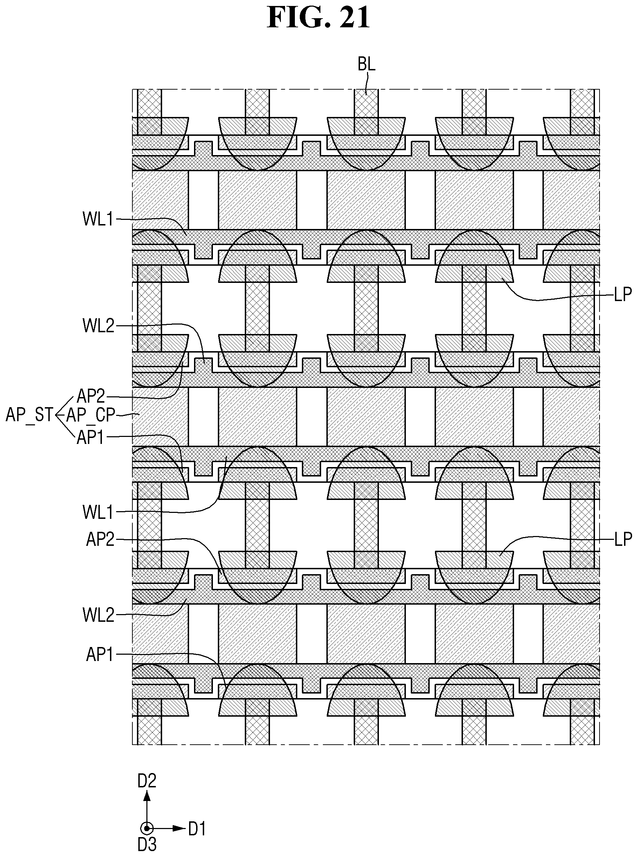

Referring to FIG. 21, in the semiconductor memory device according to some embodiments, each of the landing pads LP disposed on the first channel pattern AP1 and the second channel pattern AP2 may have a semi-circular shape or a semi-oval shape when viewed in a plan view.

When viewed in a plan view, the landing pads LP may be disposed symmetrically to each other.

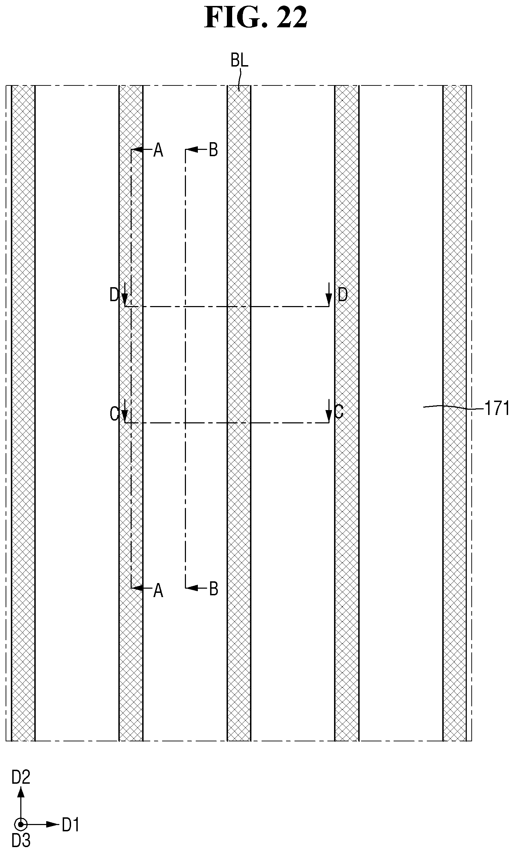

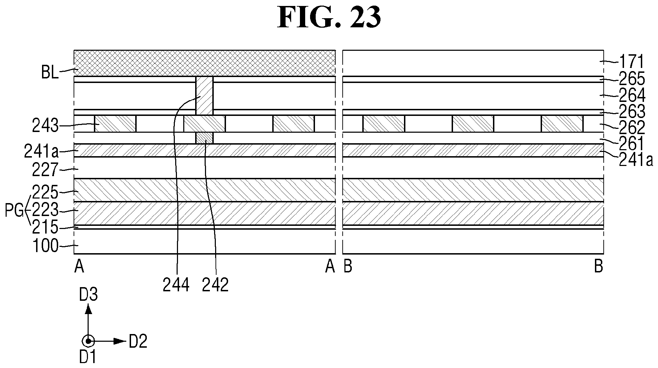

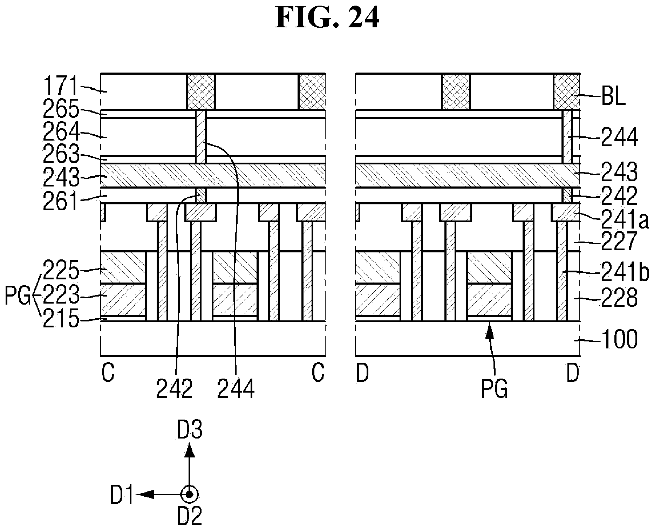

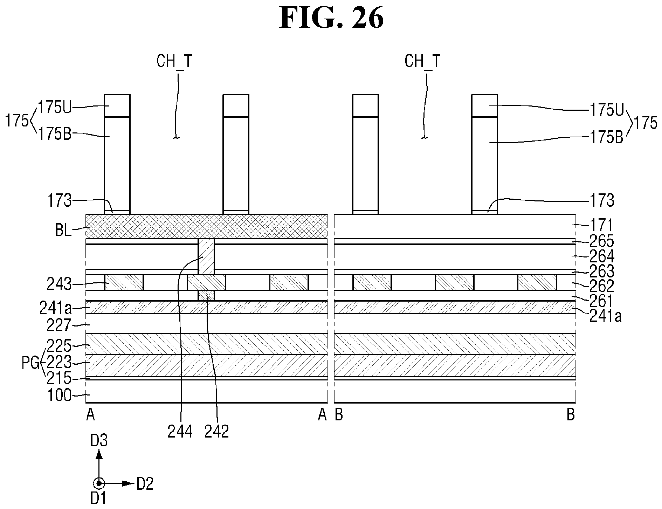

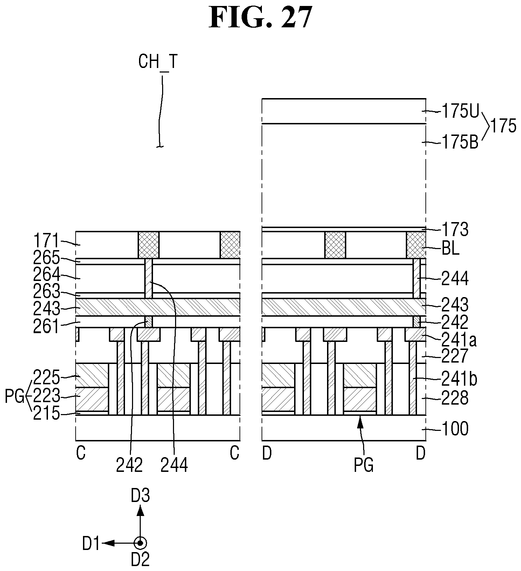

FIGS. 22 to 32 are views illustrating a method for fabricating a semiconductor memory device according to some embodiments.

Referring to FIGS. 22 to 24, the peripheral gate structure PG may be formed on the substrate 100.

The first peripheral wiring line 241a and the peripheral contact plug 241b may be formed on the substrate 100.

The peripheral upper insulating layers 261, 262, 263, 264 and 265 may be sequentially formed on the first peripheral wiring line 241a and the peripheral contact plug 241b. The second peripheral wiring line 243, the peripheral via plug 242 and the cell connection plug 244 may be formed in the peripheral upper insulating layers 261, 262, 263, 264 and 265.

Then, the bit lines BL may be formed on the fifth peripheral upper insulating layer 265. The bit line BL may extend on the substrate lengthwise in the second direction D2. The cell lower insulating layer 171 may be formed on the fifth peripheral upper insulating layer 265. The cell lower insulating layer 171 may expose the upper surface of the bit line BL.

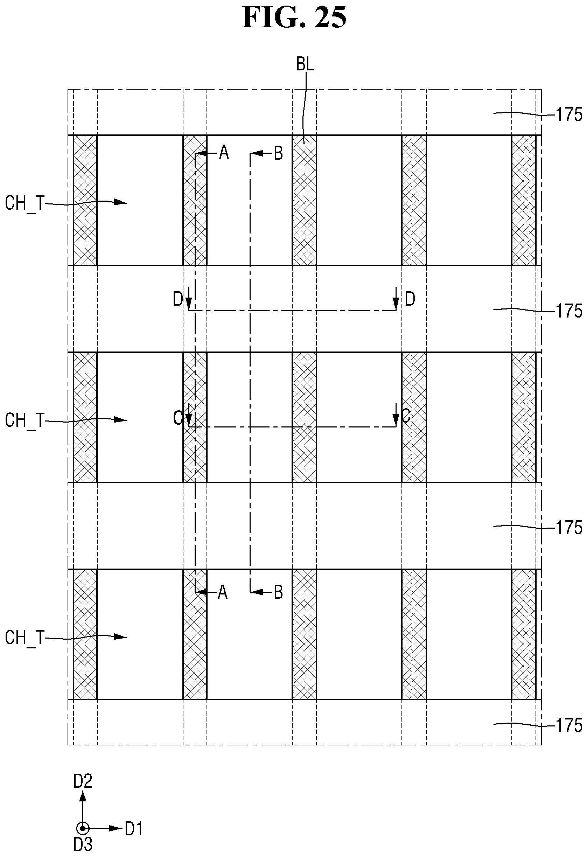

Referring to FIGS. 25 to 27, the protruded insulating pattern 175 may be formed on the substrate 100. In more detail, the protruded insulating pattern 175 may be formed on the bit line BL and the cell lower insulating layer 171.

The protruded insulating pattern 175 may include an upper protruded insulating pattern 175U and a lower protruded insulating pattern 175B. The cell lower etch stop layer 173 may be formed between the protruded insulating pattern 175 and the cell lower insulating layer 171, but is not limited thereto.

The protruded insulating pattern 175 may include a plurality of channel trenches CH_T that extends in the first direction D1. The channel trench CH_T may cross the bit line BL. The channel trench CH_T may expose the bit line BL.

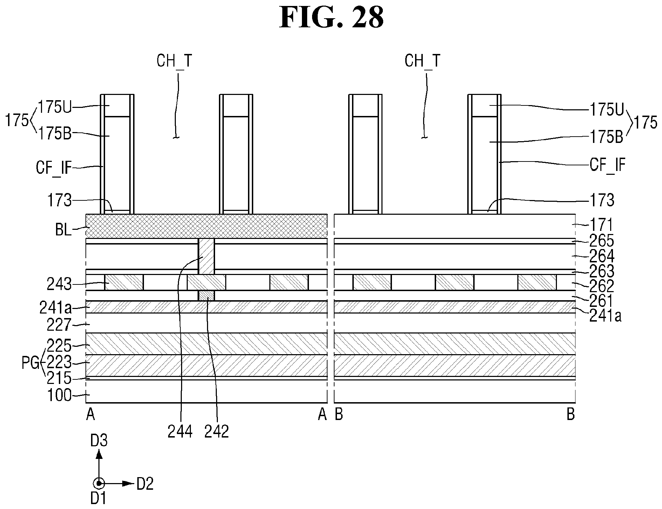

Referring to FIG. 28, the channel interfacial layer CH_IF may be formed on the sidewalls of the channel trench CH_T.

The channel interfacial layer CH_IF may extend along the sidewalls of the channel trench CH_T. The channel interfacial layer CH_IF does not extend along the bottom surface of the channel trench CH_T.

In more detail, for example, a semiconductor liner layer may be formed along the sidewalls and the bottom surface of the channel trench CH_T. The semiconductor liner layer may be anisotropically etched so that the semiconductor liner layer on the bottom surface of the channel trench CH_T may be removed. Then, the semiconductor liner layer on the sidewalls of the channel trench CH_T may be oxidized so that the channel interfacial layer CH_IF may be formed on the sidewalls of the channel trench CH_T. When the semiconductor liner layer is not entirely oxidized, the interface insertion layer (CH_IFR of FIG. 10), which is a portion of the semiconductor liner layer, may remain.

For another example, the metal oxide layer, which is an insulating material, may be formed along the sidewalls and the bottom surface of the channel trench CH_T. The metal oxide layer may be formed using, for example, an atomic layer deposition (ALD) method, but is not limited thereto. Subsequently, the metal oxide layer may be anisotropically etched so that the metal oxide layer on the bottom surface of the channel trench CH_T may be removed. As a result, the channel interfacial layer CH_IF including a second metal oxide may be formed on the sidewalls of the channel trench CH_T.

For another example, a portion of the exposed protruded insulating pattern 175 may be nitrated using a plasma nitridation process. The channel interfacial layer CH_IF may be formed on the sidewalls of the channel trench CH_T. A portion of the exposed cell lower etch stop layer 173 may be nitrated so that a portion of the channel interfacial layer CH_IF may be formed. While the plasma nitridation process is being performed, the exposed bit line BL may be also nitrated. When the bit line BL includes a metal nitride, the channel interfacial layer CH_IF may not be formed on the bit line BL. The exposed cell lower insulating layer 171 may be nitrated. In this case, although not shown, the second portion CH_IFH2 of the horizontal portion of the channel interfacial layer as shown in FIGS. 11 and 12 may be formed.

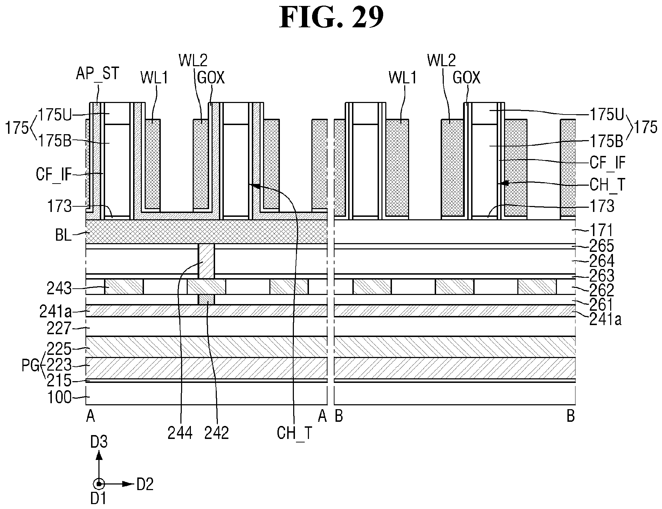

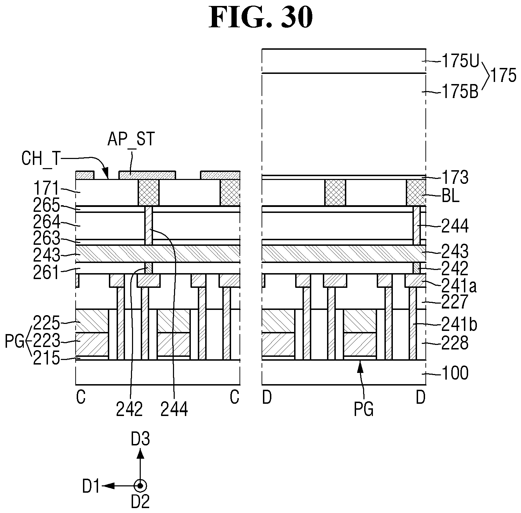

Referring to FIGS. 29 and 30, the channel structure AP_ST may be formed along the sidewalls and the bottom surface of the channel trench CH_T.

The gate insulating layer GOX may be formed on the channel structure AP_ST. The gate insulating layer GOX may be formed along a profile of the channel structure AP_ST. In a portion where the channel structure AP_ST is not formed, the gate insulating layer GOX may be formed along the sidewalls of the protruded insulating pattern 175. The gate insulating pattern GOX may be formed using at least one of physical vapor deposition (PVD), thermal chemical vapor deposition (thermal CVD), low-pressure chemical vapor deposition (LP-CVD), plasma-enhanced chemical vapor deposition (PE-CVD) or atomic layer deposition (ALD), but is not limited thereto.

The first word line WL1 and the second word line WL2 may be formed on the gate insulating pattern GOX. The first word line WL1 and the second word line WL2 may be formed along the sidewalls of the channel trench CH_T.

Forming the first word line WL1 and the second word line WL2 may include depositing a gate conductive layer on the gate insulating pattern GOX and then performing an anisotropic etching process for the gate conductive layer.

A portion of the gate insulating layer GOX may be etched during the anisotropic etching process for the gate conductive layer. As a result, the gate insulating layer GOX between the first word line WL1 and the channel structure AP_ST may be separated from the gate insulating layer GOX between the second word line WL2 and the channel structure AP_ST. Unlike the shown example, the gate insulating pattern GOX may be used as an etch stop layer during the anisotropic etching process for the gate conductive layer.

The upper surface of the first word line WL1 and the upper surface of the second word line WL2 may be positioned at a level lower than that of the upper surface of the protruded insulating pattern 175.

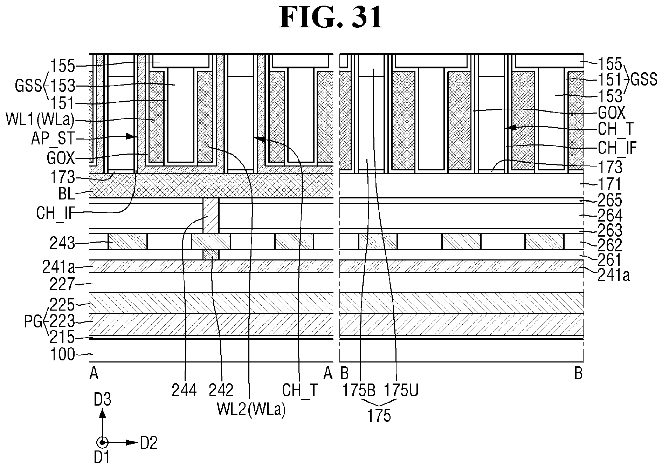

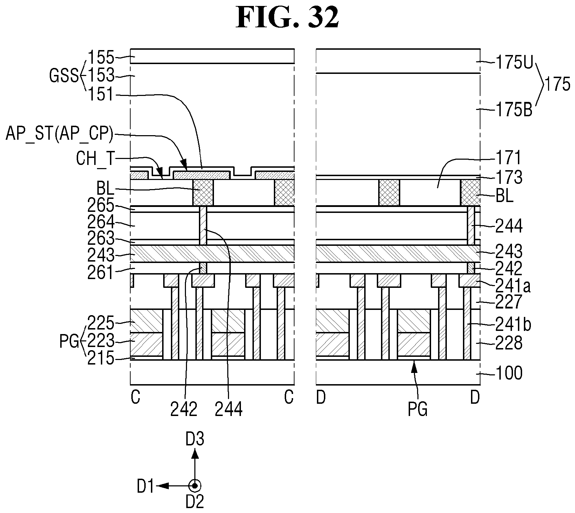

Referring to FIGS. 31 and 32, the gate isolation pattern GSS may be formed on the first word line WL1 and the second word line WL2. The gate isolation pattern GSS may fill the channel trench CH_T.

In more detail, the gate isolation liner 151 may be formed along a profile of the first word line WL1 and a profile of the second word line WL2. The gate isolation liner 151 may be also formed on the upper surface of the protruded insulating pattern 175.

A pre-filling layer may be formed on the gate isolation liner 151. The pre-filling layer may be also formed on the upper surface of the protruded insulating pattern 175. A portion of the pre-filling layer may be removed so that the gate isolation filling layer 153 may be formed on the gate isolation liner 151.

A pre-capping layer may be formed on the gate isolation filling layer 153. The pre-capping layer may be also formed on the upper surface of the protruded insulating pattern 175. A portion of the pre-capping layer may be removed so that the gate isolation capping layer 155 may be formed. While the gate isolation capping layer 155 is being formed, the gate isolation liner 151 and the pre-capping layer, which are formed on the upper surface of the protruded insulating pattern 175, may be removed.

Referring to FIGS. 2 and 3, a portion of the channel structure AP_ST may be removed so that the uppermost surface of the channel structure AP_ST may be lower than the upper surface of the protruded insulating pattern 175. Then, a pre-landing pad layer may be formed on the protruded insulating pattern 175, the gate isolation pattern GSS and the channel structure AP_ST. The pre-landing pad layer may be patterned so that the landing pads LP may be formed on the channel structure AP_ST.

Subsequently, the data storage pattern DSP may be formed on the landing pad LP. The data storage pattern DSP may be connected to the channel structure AP_ST, and may be formed on the gate isolation pattern GSS.

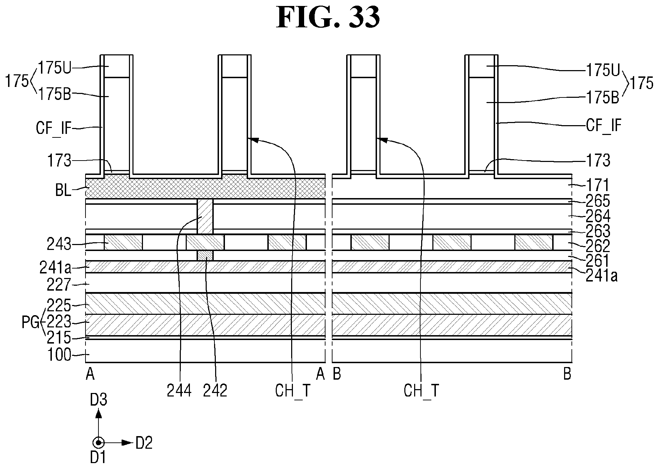

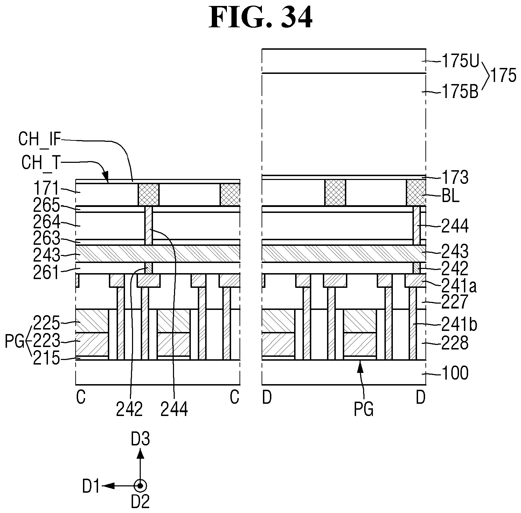

FIGS. 33 and 34 are views illustrating a method for fabricating a semiconductor memory device according to some embodiments. FIGS. 33 and 34 may be processes performed after FIGS. 25 to 27.

Referring to FIGS. 33 and 34, the channel interfacial layer CH_IF may be formed along the sidewalls and the bottom surface of the channel trench CH_T.

For example, a portion of the exposed protruded insulating pattern 175 may be nitrated using a plasma nitridation process. A portion of the exposed bit line BL and a portion of the exposed cell lower insulating layer 171 may be nitrated. As a result, the channel interfacial layer CH_IF may be formed.

Subsequently, the fabricating process described using FIGS. 29 to 32 may be performed.

Embodiments are set out in the following clauses:
Clause 1. A semiconductor memory device comprising:
   a bit line that extends in a first direction on a substrate;
   a protruded insulating pattern on the bit line and in a channel trench;
   a first channel pattern that extends along sidewalls of the channel trench and includes a first metal oxide;
   a second channel pattern that extends along the sidewalls of the channel trench, includes the first metal oxide, and is spaced apart from the first channel pattern in the first direction;
   a channel interfacial layer that extends along the sidewalls of the channel trench, and is in contact with the first channel pattern and the second channel pattern;
   a first word line between the first channel pattern and the second channel pattern, and that extends in a second direction that intersects that first direction;
   a second word line between the first channel pattern and the second channel pattern, that extends in the second direction, and is spaced apart from the first word line in the first direction; and
   a first capacitor and a second capacitor which are electrically connected to the first channel pattern and the second channel pattern, respectively.
Clause 2. The semiconductor memory device of clause 1, wherein the first channel pattern and the second channel pattern are in contact with an upper surface of the bit line.
Clause 3. The semiconductor memory device of clause 2, wherein the channel interfacial layer includes at least one of a silicon oxide, a silicon oxynitride, a silicon nitride or a second metal oxide, and
   wherein the second metal oxide comprises an insulating material.
Clause 4. The semiconductor memory device of any preceding clause, wherein the channel interfacial layer extends along a bottom surface of the channel trench, and
   wherein the channel interfacial layer includes a horizontal portion that extends along the bottom surface of the channel trench and a vertical portion that extends along the sidewall of the channel trench.
Clause 5. The semiconductor memory device of clause 4, wherein the horizontal portion of the channel interfacial layer includes a material different from that of the vertical portion of the channel interfacial layer.
Clause 6. The semiconductor memory device of clause 5, wherein the horizontal portion of the channel interfacial layer includes a metal nitride, and
   wherein the vertical portion of the channel interfacial layer includes one of a silicon nitride or a silicon oxynitride.
Clause 7. The semiconductor memory device of any preceding clause, wherein the protruded insulating pattern includes a lower protruded insulating pattern and an upper protruded insulating pattern, and
   wherein the lower protruded insulating pattern is between the bit line and the upper protruded insulating pattern.
Clause 8. The semiconductor memory device of any preceding clause, wherein the first word line includes a first portion and a second portion, and
   wherein a width of the first portion of the first word line in the first direction is less than a width of the second portion of the first word line in the first direction.
Clause 9. The semiconductor memory device of any preceding clause, further comprising:
   a gate isolation pattern on the bit line, wherein the gate isolation pattern separates the first word line and the second word line from each other,
   wherein the first channel pattern and the second channel pattern are connected to each other by a connection channel pattern, and
   wherein the gate isolation pattern is on the connection channel pattern.
Clause 10. The semiconductor memory device of any preceding clause, further comprising:
   a gate insulating layer between the first channel pattern and the first word line,
   wherein a height from an upper surface of the bit line to an uppermost portion of the gate insulating layer is greater than a height from the upper surface of the bit line to an uppermost portion of the first channel pattern.
Clause 11. A semiconductor memory device comprising:
   a peripheral gate structure on a substrate;
   a bit line on the peripheral gate structure, wherein the bit line extends in a first direction;
   a protruded insulating pattern on the bit line, and in a channel trench;
   a channel structure on the bit line, wherein the channel structure includes a horizontal portion and first and second vertical portions which are inside the channel trench, wherein the first and second vertical portions protrude from the horizontal portion, and wherein the horizontal portion of the channel structure is in contact with the bit line;
   a channel interfacial layer between the protruded insulating pattern and the channel structure;
   a first word line on the channel structure, wherein the first word line extends in a second direction that intersects the first direction;
   a second word line on the channel structure, wherein the second word line extends in the second direction and is spaced apart from the first word line in the first direction;
   a gate isolation pattern on the horizontal portion of the channel structure, wherein the gate isolation pattern separates the first word line and the second word line from each other; and
   a first capacitor and a second capacitor which are electrically connected to the first vertical portion of the channel structure and the second vertical portion of the channel structure, respectively.
Clause 12. The semiconductor memory device of clause 11, wherein the channel interfacial layer includes at least one of a silicon oxide, a silicon oxynitride, a silicon nitride or a metal oxide.
Clause 13. The semiconductor memory device of clause 12, wherein the metal oxide is an insulating material.
Clause 14. The semiconductor memory device of any of clauses 11-13, wherein a height from an upper surface of the bit line to an upper surface of the gate isolation pattern is greater than a height from the upper surface of the bit line to an uppermost portion of the first vertical portion of the channel structure.
Clause 15. The semiconductor memory device of any of clauses 11-14, wherein the protruded insulating pattern includes a lower protruded insulating pattern and an upper protruded insulating pattern,
   wherein the lower protruded insulating pattern is between the bit line and the upper protruded insulating pattern,
   wherein the lower protruded insulating pattern includes a silicon oxide, and
   wherein the upper protruded insulating pattern includes a silicon nitride.
Clause 16. A semiconductor memory device comprising;
   a peripheral gate structure on a substrate;
   a bit line on the peripheral gate structure, wherein the bit line extends in a first direction;
   a protruded insulating pattern on the bit line and in a channel trench;
   a channel structure on the bit line, wherein the channel structure includes a horizontal portion and first and second vertical portions, which are inside the channel trench, wherein the first and second vertical portions protrude from the horizontal portion, and wherein the horizontal portion of the channel structure is separated from the bit line;
   a channel interfacial layer that is between the protruded insulating pattern and the channel structure, and that is between the bit line and the channel structure;
   a first word line on the channel structure, wherein the first word line extends in a second direction that intersects the first direction;
   a second word line on the channel structure, wherein the second word line extends in the second direction and is spaced apart from the first word line in the first direction;
   a gate isolation pattern on the horizontal portion of the channel structure, wherein the gate isolation pattern separates the first word line and the second word line from each other; and
   a first capacitor and a second capacitor, which are electrically connected to the first vertical portion of the channel structure and the second vertical portion of the channel structure, respectively.
Clause 17. The semiconductor memory device of clause 16, wherein the channel interfacial layer includes a horizontal portion that extends along a bottom surface of the channel trench, and is in contact with the bit line, and a vertical portion that extends along sidewalls of the channel trench, and
   wherein the horizontal portion of the channel interfacial layer includes a material different from that of the vertical portion of the channel interfacial layer.
Clause 18. The semiconductor memory device of clause 17, wherein the horizontal portion of the channel interfacial layer includes a metal nitride, and
   wherein the vertical portion of the channel interfacial layer includes one of a silicon nitride or a silicon oxynitride.
Clause 19. The semiconductor memory device of clause 18, wherein the bit line includes a first metal, and
   wherein the metal nitride is a nitride of the first metal.
Clause 20. The semiconductor memory device of any of clauses 16-19, further comprising:
   a gate insulating layer between the channel structure and the first word line,
   wherein a height from an upper surface of the bit line to an uppermost portion of the gate insulating layer is greater than a height from the upper surface of the bit line to an uppermost portion of the first vertical portion of the channel structure.

In concluding the detailed description, those skilled in the art will appreciate that many variations and modifications may be made to the described embodiments without substantially departing from the principles of the present inventive concept. Therefore, the disclosed embodiments of the disclosure are used in a generic and descriptive sense only and not for purposes of limitation.

## Claims

1. A semiconductor memory device comprising:
a bit line that extends in a first direction on a substrate;
a protruded insulating pattern on the bit line;
a first channel pattern that extends along a first sidewall of a channel trench and includes a first metal oxide;
a second channel pattern that extends along a second sidewall of the channel trench, includes the first metal oxide, and is spaced apart from the first channel pattern in the first direction;
a channel interfacial layer that extends along the first and second sidewalls of the channel trench, and is in contact with the first channel pattern and the second channel pattern;
a first word line between the first channel pattern and the second channel pattern, and that extends in a second direction that intersects that first direction;
a second word line between the first channel pattern and the second channel pattern, that extends in the second direction, and is spaced apart from the first word line in the first direction; and
a first capacitor and a second capacitor which are electrically connected to the first channel pattern and the second channel pattern, respectively.

2. The semiconductor memory device of claim 1, wherein the first channel pattern and the second channel pattern are in contact with an upper surface of the bit line.

3. The semiconductor memory device of claim 2, wherein the channel interfacial layer includes at least one of a silicon oxide, a silicon oxynitride, a silicon nitride or a second metal oxide, and
wherein the second metal oxide comprises an insulating material.

4. The semiconductor memory device of any preceding claim, wherein the channel interfacial layer extends along a bottom surface of the channel trench, and
wherein the channel interfacial layer includes a horizontal portion that extends along the bottom surface of the channel trench, a first vertical portion that extends along the first sidewall of the channel trench, and second vertical portion that extends along the second sidewall of the channel trench.

5. The semiconductor memory device of claim 4, wherein the horizontal portion of the channel interfacial layer includes a material different from that of the first and second vertical portions of the channel interfacial layer.

6. The semiconductor memory device of any preceding claim, wherein the protruded insulating pattern includes a lower protruded insulating pattern and an upper protruded insulating pattern, and
wherein the lower protruded insulating pattern is between the bit line and the upper protruded insulating pattern.

7. The semiconductor memory device of any preceding claim, wherein the first word line includes a first portion and a second portion, and
wherein a width of the first portion of the first word line in the first direction is less than a width of the second portion of the first word line in the first direction.

8. The semiconductor memory device of any preceding claim, further comprising:
a gate isolation pattern on the bit line, wherein the gate isolation pattern separates the first word line and the second word line from each other,
wherein the first channel pattern and the second channel pattern are connected to each other by a connection channel pattern, and
wherein the gate isolation pattern is on the connection channel pattern.

9. The semiconductor memory device of any preceding claim, further comprising:
a gate insulating layer between the first channel pattern and the first word line,
wherein a height from an upper surface of the bit line to an uppermost portion of the gate insulating layer is greater than a height from the upper surface of the bit line to an uppermost portion of the first channel pattern.

10. A semiconductor memory device comprising:
a peripheral gate structure on a substrate;
a bit line on the peripheral gate structure, wherein the bit line extends in a first direction;
a protruded insulating pattern on the bit line;
a channel structure on the bit line, and in a channel trench, wherein the channel structure includes a horizontal portion and first and second vertical portions which are inside the channel trench, wherein the first and second vertical portions protrude from the horizontal portion, and wherein the horizontal portion of the channel structure is in contact with the bit line;
a channel interfacial layer between the protruded insulating pattern and the channel structure;
a first word line on the channel structure, wherein the first word line extends in a second direction that intersects the first direction;
a second word line on the channel structure, wherein the second word line extends in the second direction and is spaced apart from the first word line in the first direction;
a gate isolation pattern on the horizontal portion of the channel structure, wherein the gate isolation pattern separates the first word line and the second word line from each other; and
a first capacitor and a second capacitor which are electrically connected to the first vertical portion of the channel structure and the second vertical portion of the channel structure, respectively.

11. The semiconductor memory device of claim 10, wherein the channel interfacial layer includes at least one of a silicon oxide, a silicon oxynitride, a silicon nitride or a metal oxide.

12. The semiconductor memory device of claim 10 or claim 11, wherein a height from an upper surface of the bit line to an upper surface of the gate isolation pattern is greater than a height from the upper surface of the bit line to an uppermost portion of the first vertical portion of the channel structure.

13. The semiconductor memory device of any of claims 10-12, wherein the protruded insulating pattern includes a lower protruded insulating pattern and an upper protruded insulating pattern,
wherein the lower protruded insulating pattern is between the bit line and the upper protruded insulating pattern,
wherein the lower protruded insulating pattern includes a silicon oxide, and
wherein the upper protruded insulating pattern includes a silicon nitride.

14. The semiconductor memory device of any of claims 10-13 wherein the channel interfacial layer is between the bit line and the channel structure.

15. The semiconductor memory device of claim 14, wherein the channel interfacial layer includes a horizontal portion that extends along a bottom surface of the channel trench, and is in contact with the bit line, and a vertical portion that extends along sidewalls of the channel trench, and
wherein the horizontal portion of the channel interfacial layer includes a material different from that of the vertical portion of the channel interfacial layer.
